# EUROPEAN PATENT APPLICATION

(11) **EP 4 495 689 A1**
(43) Date of publication of application: **22.01.2025**
(21) Application number: 24185616.0
(22) Date of filing: 01.07.2024
(51) Int. Cl.: G03F 7/09

(54) **METHOD FOR FORMING RESIST UNDERLAYER FILM AND PATTERNING PROCESS**

(30) Priority: 07.07.2023 JP 2023112104
(71) Applicant: SHIN-ETSU CHEMICAL CO., LTD., Tokyo 1000005 (JP)
(72) Inventor: Kobayashi, Naoki, Niigata (JP); Ishiwata, Kenta, Niigata (JP); Kori, Daisuke, Niigata (JP); Yano, Toshiharu, Niigata (JP)
(74) Representative: Sonnenhauser, Thomas Martin

(57) **Abstract**

The present invention is a method for forming a resist underlayer film on a substrate, the method including the steps of: (i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and (ii) forming a resist underlayer film by curing the underlayer-film-precursor film by plasma irradiation, where the polymer (A) is an aromatic ring-containing resin containing no hydroxy groups or organic groups represented by the following general formulae (1) in a repeating unit contained in the polymer, where "p" represents 0 or 1, and "*" represents an attachment point. This can provide a method for forming a resist underlayer film according to which it is possible to form a resist underlayer film that exhibits excellent dry etching resistance.

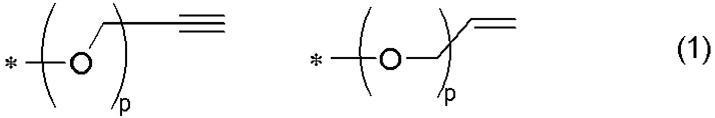

## Description

### TECHNICAL FIELD

The present invention relates to: a method for forming a resist underlayer film; and a patterning process. More specifically, the present invention relates to: a method for forming a resist underlayer film usable for fine patterning according to a multilayer resist method in a semiconductor device manufacturing process; and a patterning process using the resist under layer film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a material used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as, for example, disclosed in Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type organic underlayer film composition excellent in filling and planarizing properties, for example, the composition disclosed in Patent Document 2 has been reported. However, in view of application of this composition in the advanced generation, there is a concern about dry etching resistance. The application limit of the conventional coating-type resist underlayer film compositions is thus approaching.

To solve the above problems, Patent Document 3 reports that etching resistance at the time of substrate processing can be improved by irradiating the resist underlayer film with plasma or an electron beam. However, many of the resist underlayer films used in the Examples contain a resin or a compound containing hydroxy groups or propargyl groups, and a crosslinking reaction also progresses competitively at the time of plasma irradiation or electron beam irradiation. Therefore, modification of the resist underlayer films is expected to be insufficient. In addition, the resist underlayer films are thought to be unfavorable from the viewpoint of etching resistance, since oxygen atoms remain in the films.

### CITATION LIST

### PATENT LITERATURE

Patent Document 1: JP2004-205685A
Patent Document 2: JP2017-119671A
Patent Document 3: JP2020-183506A

### SUMMARY OF INVENTION

### TECHNICAL PROBLEM

The present invention has been made in view of the above-described circumstances. An object of the present invention is to provide: a method for forming a resist underlayer film according to which it is possible to form a resist underlayer film that exhibits much better dry etching resistance than when a conventional organic underlayer film material is used; and a patterning process in which the method for forming a resist underlayer film is used.

### SOLUTION TO PROBLEM

To achieve the object, the present invention provides a method for forming a resist underlayer film on a substrate, the method comprising the steps of:
(i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and
(ii) forming a resist underlayer film by curing the underlayer-film-precursor film by plasma irradiation,
wherein the polymer (A) is an aromatic ring-containing resin containing no hydroxy groups or organic groups represented by the following general formulae (1) in a repeating unit contained in the polymer, 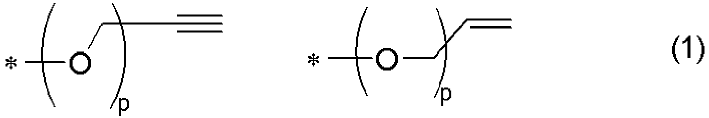 wherein "p" represents 0 or 1, and "*" represents an attachment point.

According to such a method for forming a resist underlayer film, modification of the film by irradiation with plasma occurs easily, and it is possible to provide a resist underlayer film excellent in dry etching resistance. If a hydroxy group or an organic group represented by either of the general formulae (1) is contained, thermosetting progresses actively, and therefore, there are few active sites in the film that are modified by plasma irradiation. Therefore, such a case is not favorable.

The aromatic ring-containing resin of the polymer (A) preferably contains a structure selected from the group consisting of structures shown by the following formulae (1-1).

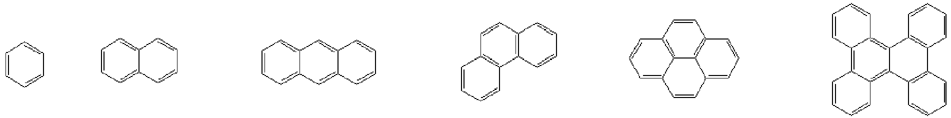

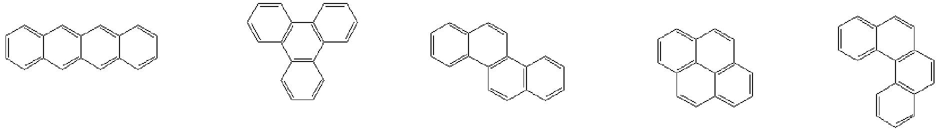

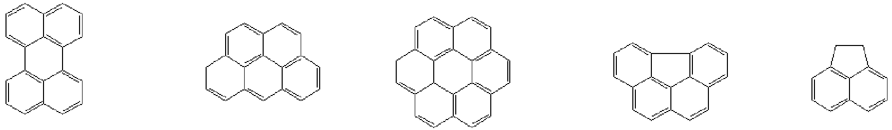

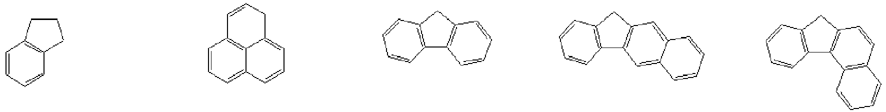

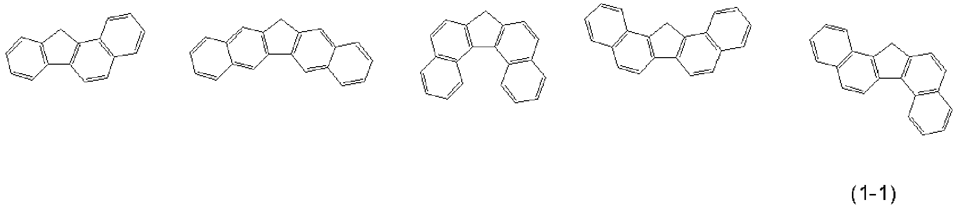

When a resin containing a structure shown above is used, modification of the film by plasma irradiation occurs further easily, and it is possible to provide a resist underlayer film further excellent in dry etching resistance.

The polymer (A) preferably has any of constitutional units represented by the following general formulae (A-1), (A-2), (A-3), (A-4), and (A-5), 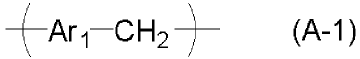 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1), 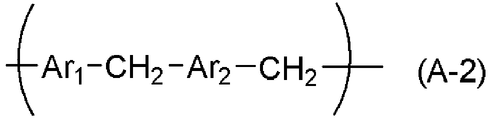 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1); and Ar₂ is a different fused aromatic ring from Ar₁, and represents an unsubstituted fused aromatic ring or a fused aromatic ring containing, as a substituent, a divalent organic group having 1 to 20 carbon atoms and containing no hydroxy groups or organic groups represented by the general formulae (1), 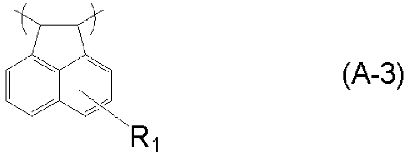 wherein R₁ represents a hydrogen atom, a halogen atom, or a linear, branched, or cyclic hydrocarbon group having 1 to 20 carbon atoms, 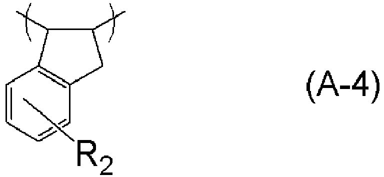 wherein R₂ represents a hydrogen atom, a halogen atom, or a linear, branched, or cyclic hydrocarbon group having 1 to 20 carbon atoms, 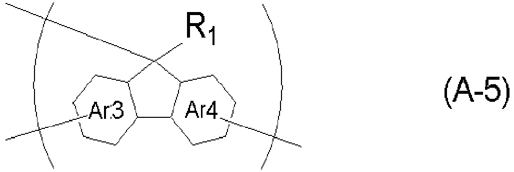 wherein R₁ represents a hydrogen atom or a monovalent organic group having 1 to 50 carbon atoms and containing no hydroxy groups or organic groups represented by the general formulae (1); and Ar3 and Ar4 each represent an unsubstituted benzene ring or naphthalene ring.

By using a composition containing a resin having any of the constitutional units represented by the general formulae (A-1) to (A-5), it is possible to enhance further the dry etching resistance after the plasma irradiation.

The polymer (A) preferably has a molecular weight of 300 to 5,000 as measured by gel permeation chromatography in terms of polystyrene.

According to a method for forming a resist underlayer film in which a composition for forming a resist underlayer film, containing a resin having a weight-average molecular weight in such a range, is used, solubility in an organic solvent is not degraded, and outgas during baking can be suppressed.

The composition for forming a resist underlayer film preferably further contains one or more of:
(C) a crosslinking agent;
(D) a surfactant;
(E) an acid generator; and
(F) a plasticizer.

By using a composition for forming a resist underlayer film containing an additive given above, it is possible to adjust, within appropriate ranges, various physical properties, such as coating property, dry etching resistance, and filling and planarizing properties, required when the composition is used for forming the resist underlayer film.

In this case, the crosslinking agent (C) preferably has a structure represented by the following general formula (C-1), 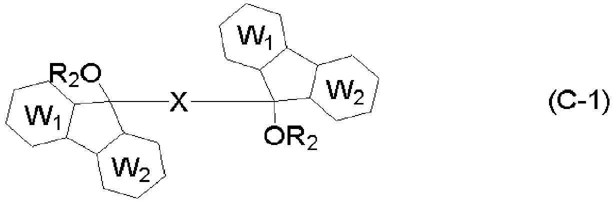 wherein W₁ and W₂ each represent a benzene ring or naphthalene ring optionally having a substituent; R₂ represents a hydrogen atom or a monovalent organic group having 1 to 20 carbon atoms; and X represents any group represented by the following general formulae (2).

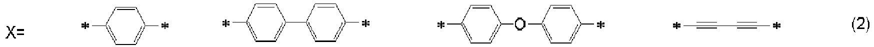

When the composition contains a crosslinking agent having the structure represented by the general formula (C-1), the resist underlayer film irradiated with plasma can provide excellent film thickness uniformity.

The plasma irradiation in the step (ii) can be performed under an atmosphere of N₂, NF₃, H₂, fluorocarbon, a rare gas, or a mixture of any thereof.

When the resist underlayer film is cured by such a method, it is possible to provide a resist underlayer film that exhibits better dry etching resistance than when a method of curing only by heating is used.

The heat treatment in the step (i) can be performed under an atmosphere with an oxygen concentration of 1% or more and 21% or less.

According to such a method, it is possible to activate reactive sites of the resin in the resist-underlayer-film-precursor film to promote the curing reaction caused by the plasma irradiation.

Alternatively, the heat treatment in the step (i) can also be performed under an atmosphere with an oxygen concentration of less than 1%.

According to such a method, it is possible to activate reactive sites of the resin in the resist-underlayer-film-precursor film to promote the curing reaction by the plasma irradiation, without causing degradation of the substrate to be processed even when the substrate to be processed includes a material that is unstable to heating under an oxygen atmosphere. Therefore, such a method is useful.

The present invention also provides a patterning process for forming a pattern in a substrate to be processed, comprising the steps of:
(I-1) forming a resist underlayer film on a substrate to be processed by the inventive method for forming a resist underlayer film;
(I-2) forming a resist middle layer film on the resist underlayer film;
(I-3) forming a resist upper layer film on the resist middle layer film by using a photoresist material;
(I-4) subjecting the resist upper layer film to pattern exposure and then to development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(1-7) processing the substrate to be processed while using the resist underlayer film having the formed pattern as a mask to form the pattern in the substrate to be processed.

According to the above-described patterning process, it is possible to use a resist underlayer film that exhibits excellent dry etching resistance, and therefore, a fine pattern can be formed with high precision in a substrate, being a body to be processed.

### ADVANTAGEOUS EFFECTS OF INVENTION

As described above, according to the inventive method for forming a resist underlayer film, it is possible to form a resist underlayer film that exhibits much better dry etching resistance than conventional organic underlayer film materials.

In addition, according to the inventive patterning process, it is possible to form a fine pattern with high accuracy in a substrate, which is a body to be processed.

Furthermore, the inventive method for forming a resist underlayer film and patterning process are suitably used particularly in a multilayer resist process, including filling and planarization of a substrate to be processed having steps and irregularities, and are significantly useful in fine patterning for the manufacture of semiconductor devices. In particular, in a fine patterning process using a multilayer resist method in a semiconductor device manufacturing process, even on a substrate to be processed having a portion where filling and planarization are difficult, such as a portion with a dense fine pattern structure portion with a high aspect ratio typified by a DRAM under progressing miniaturization, filling can be performed without causing defects such as voids and peeling. Therefore, a resist underlayer film having excellent planarizing property can be formed. Furthermore, the present inventions exhibit better etching resistance than conventional methods for forming a resist underlayer film, and the effect can be exhibited particularly by performing plasma irradiation. Accordingly, it is possible to form a fine pattern in a body to be processed with even higher accuracy.

### BRIEF DESCRIPTION OF DRAWINGS

FIG. 1 is an explanatory view of an example (three-layer resist process) of the patterning process of the present invention.
FIG. 2 is an explanatory view of a method for evaluating the filling property.

### DESCRIPTION OF EMBODIMENTS

As stated above, there have been demands for the development of: a patterning process that makes it possible to transfer a resist pattern to a substrate to be processed with higher precision in a fine patterning process according to a multilayer resist method; and a formation method by which it is possible to form a resist underlayer film useful for such a patterning process.

Patent Document 3 reports that dry etching resistance of a resist underlayer film during substrate processing is enhanced by performing plasma irradiation. It is considered that carbon bonds of the resist underlayer film are dissociated and recombined by plasma irradiation to reconstruct a cured film having a diamond-like carbon structure, and that plasma irradiation contributes to increase in hardness and density in this manner. On the other hand, the compositions for forming a resist underlayer film used in the Examples of Patent Document 3 contain a hydroxy group and an organic group represented by the general formulae (1), and therefore, it is presumed that not only dissociation and recombination of carbon bonds but also a crosslinking reaction occurs competitively. For this reason, the present inventors have conjectured that film modification by irradiation with plasma may not progress sufficiently.

The present inventors have searched for a method for forming a resist underlayer film according to which dissociation and recombination of carbon bonds are caused actively by plasma irradiation, and studied earnestly. As a result, the present inventors have found out that, according to a method for forming an underlayer film, including a step of forming an underlayer-film-precursor film by applying a composition for forming a resist underlayer film, containing an aromatic ring-containing resin (polymer (A)) containing no hydroxy groups or organic groups represented by the general formulae (1) and an organic solvent, and subjecting the applied film to heat treatment at a temperature of 100°C or higher and 800°C or lower for 10 seconds to 7,200 seconds to cure the film, and a step of forming a resist underlayer film by curing the underlayer-film-precursor film by plasma irradiation, it is possible to form a resist underlayer film that exhibits much better dry etching resistance than conventional methods for forming a resist underlayer film, using plasma irradiation. Thus, the present invention has been completed.

That is, the present invention is a method for forming a resist underlayer film on a substrate, the method comprising the steps of:
(i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and
(ii) forming a resist underlayer film by curing the underlayer-film-precursor film by plasma irradiation,
wherein the polymer (A) is an aromatic ring-containing resin containing no hydroxy groups or organic groups represented by the following general formulae (1) in a repeating unit contained in the polymer, 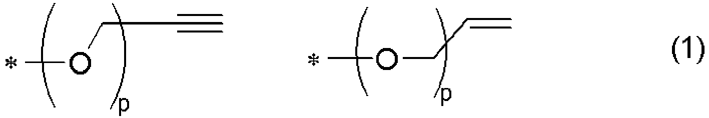 wherein "p" represents 0 or 1, and "*" represents an attachment point.

In addition, the present invention is a patterning process for forming a pattern in a substrate to be processed, comprising the steps of:
(I-1) forming a resist underlayer film on a substrate to be processed by the inventive method for forming a resist underlayer film;
(I-2) forming a resist middle layer film on the resist underlayer film;
(I-3) forming a resist upper layer film on the resist middle layer film by using a photoresist material;
(I-4) subjecting the resist upper layer film to pattern exposure and then to development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.

Hereinafter, the present invention will be described in detail, but the present invention is not limited thereto.

### <Method for Forming Resist Underlayer Film>

The present invention is a method for forming a resist underlayer film on a substrate, the method including the steps of:
(i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and
(ii) forming a resist underlayer film by curing the underlayer-film-precursor film by plasma irradiation,
where the polymer (A) is an aromatic ring-containing resin containing no hydroxy groups or organic groups represented by the following general formulae (1) in a repeating unit contained in the polymer.

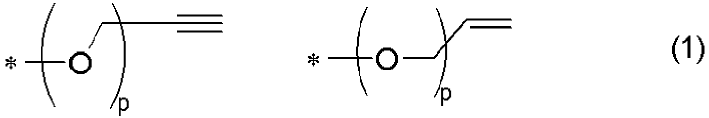

In the general formulae (1), "p" represents 0 or 1, and "*" represents an attachment point.

According to such a method for forming a resist underlayer film, it is possible to form a resist underlayer film excellent in dry etching resistance at the time of substrate processing. More specifically, according to such a method for forming a resist underlayer film, modification of the film caused by plasma irradiation occurs easily, and thus, a resist underlayer film excellent in dry etching resistance can be formed.

The method for applying the composition for forming a resist underlayer film in the step (i) is not particularly limited. Details of the composition for forming a resist underlayer film will be given later.

In the step (i), the temperature at which to heat-treat (bake) the coating film is 100°C or higher and 800°C or lower, preferably 150°C or higher and 600°C or lower, and further preferably 150°C or higher and 400°C or lower. The baking time is in a range of 10 seconds to 7,200 seconds, further preferably 30 seconds to 600 seconds.

By adjusting appropriately the baking temperature and time within the above-described ranges, it is possible to achieve curing properties, such as planarizing and filling properties, dry etching resistance, and heat resistance, suitable for the purpose. By performing the heat treatment (baking) within a temperature range of 150°C or higher and 400°C or lower, a state is achieved, where many active sites, at which dissociation and recombination of carbon bonds in the underlayer-film-precursor film occur, are contained in the film, and film modification by irradiation with plasma is more easily promoted, so that a resist underlayer film excellent in dry etching resistance can be formed. When the baking temperature is 100°C or higher, the solvent remaining in the film can be reduced, and degradation in film thickness uniformity due to plasma irradiation can be suppressed. When the baking temperature is 800°C or lower, thermal decomposition of the base resin can be suppressed, and it is possible to provide a resist underlayer film with little sublimation product. It is also possible to perform the heat treatment in multiple steps (step-baking) .

Furthermore, in the step (i), the heat treatment can be performed under an atmosphere having an oxygen concentration of 1% or more and 21% or less.

According to such a method, it is possible to activate reactive sites of the resin in the resist-underlayer-film-precursor film to promote the curing reaction performed by plasma irradiation.

Alternatively, in the step (i), the heat treatment can be performed under an atmosphere having an oxygen concentration of less than 1%.

As the atmosphere during the baking, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

For the plasma irradiation, a known method can be used. Examples include methods disclosed in JP5746670B2 and "Improvement of the wiggling profile of spin-on carbon hard mask by H2 plasma treatment" (J. Vac. Sci. Technol. B26 (1), Jan/Feb 2008, p67-71).

RF discharge power is preferably 100 to 10,000 W, more suitably 500 to 5,000 W.

Examples of the gas atmosphere include N₂, NF₃, H₂, rare gases such as He, and fluorocarbon; and more suitable examples include He, Ar, N₂, Ne, NF₃, H₂, CF₄, CHF₃, CH₂F₂, CH₃F, C₄F₆, C₄F₈, etc. These gases may be used as a mixture of two or more kinds. An advantage of the present invention is that the advantageous effects of the present invention can be expected even when using a gas atmosphere not containing O₂.

The time of the plasma irradiation can be selected from, for example, 10 to 240 seconds. The pressure can be selected appropriately.

In the step (ii), the plasma irradiation is preferably performed under an atmosphere of N₂, NF₃, H₂, fluorocarbon, a rare gas such as He, or a mixture of any thereof.

From the viewpoint of productivity, examples of particularly favorable gas atmospheres include He, Ar, N₂, H₂, etc.

After the plasma irradiation, the resist underlayer film may be subjected to heat treatment. When heating is to be performed after the plasma irradiation, as heating conditions, the heating temperature can be selected appropriately from the range of 80 to 800°C (preferably 100 to 700°C, more preferably 200 to 600°C), and the heating time from the range of 30 to 180 seconds (preferably 30 to 120 seconds). Without wishing to be bound by any theory, it is considered that, by performing high-temperature heating after the plasma irradiation, dangling bonds are bonded to each other, and this can contribute to higher density of the cured film (resist underlayer film).

As the atmosphere during the heating after the plasma irradiation, it is possible to select, as necessary, an oxygen-containing atmosphere (oxygen concentration: 1% to 210), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

The irradiation apparatus is not particularly limited as long as plasma irradiation can be performed with the apparatus, and for example, it is possible to use Telius SP or Tactras Vigus manufactured by Tokyo Electron Ltd. It is possible to select an apparatus and set conditions in such a manner as to achieve the advantageous effects of the present invention more prominently.

In the inventive patterning process, using the composition for forming a resist underlayer film described in detail below, it is preferable to use a substrate to be processed having a structure or step having a height of 30 nm or more. The composition for forming a resist underlayer film used in the present invention is excellent in filling and planarizing properties, and therefore, a flat resist underlayer film (cured film) can be formed even when the substrate to be processed has a structure or step (irregularities) having a height of 30 nm or more. The height of the structure or step that the substrate to be processed has is preferably 30 nm or more, more preferably 50 nm or more, and more preferably 100 nm or more. In a method for processing a stepped substrate having a pattern of the above-described height, by forming a resist underlayer film according to the inventive method for forming a resist underlayer film to perform filling and planarization, it is possible to achieve a uniform film thickness in the subsequently formed resist middle layer film and resist upper layer film, and therefore, exposure depth margin (DOF) at the time of photolithography can be ensured easily, and this is extremely favorable.

### <Composition for Forming Resist Underlayer Film>

In the inventive method for forming a resist underlayer film, a composition for forming a resist underlayer film containing a polymer (A) and an organic solvent is used, and as the polymer, used is an aromatic ring-containing resin containing no hydroxy groups or organic groups represented by the following general formulae (1) in a repeating unit contained in the polymer.

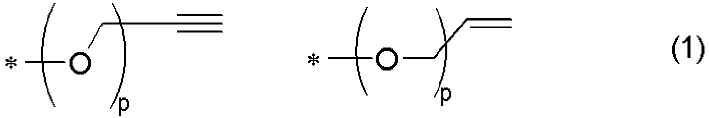

In the general formulae (1), "p" represents 0 or 1, and "*" represents an attachment point.

### [(A) Polymer (Resin)]

By using, as the polymer (A), an aromatic ring-containing resin containing no hydroxy groups or organic groups represented by the general formulae (1) in a repeating unit contained in the polymer, modification of the resist underlayer film by plasma irradiation is facilitated, and it is possible to form a resist underlayer film excellent in etching resistance at the time of substrate processing.

The polymer (A) is preferably a resin containing a structure selected from the group consisting of structures shown by the following formulae (1-1).

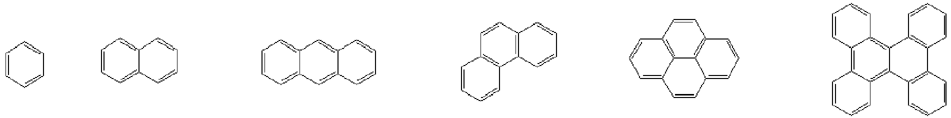

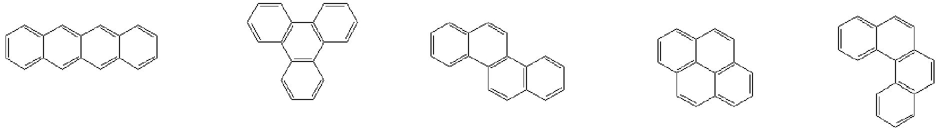

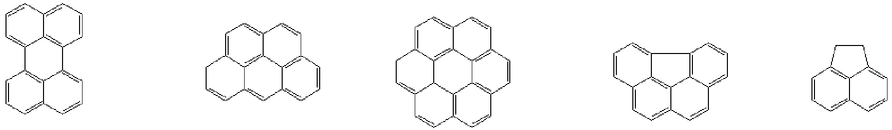

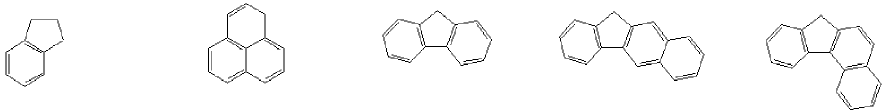

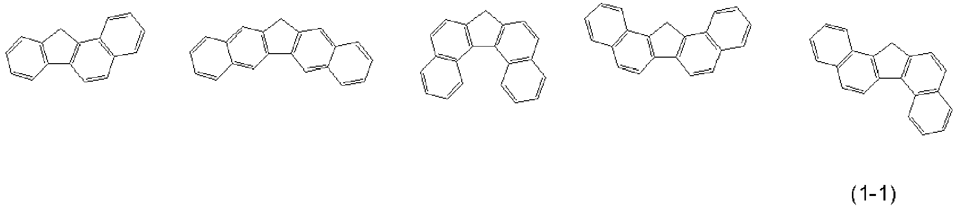

When a fused aromatic ring having a high carbon density shown above is contained, the modification of the resist-underlayer-film-precursor film by plasma irradiation occurs easily, and it is possible to form a resist underlayer film having better dry etching resistance at the time of substrate processing.

The polymer (A) is preferably a resin having any one or more constitutional units represented by the following general formulae (A-1) to (A-5).

### (Constitutional Units: A-1 and A-2)

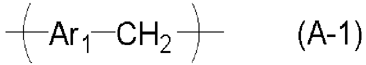

In the general formula (A-1), Ar₁ represents an unsubstituted fused aromatic ring or a fused aromatic ring containing, as a substituent, a divalent organic group having 1 to 20 carbon atoms and containing no hydroxy groups or organic groups represented by the general formulae (1).

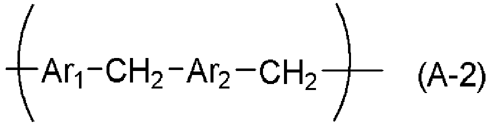

In the general formula (A-2), Ar₁ represents an unsubstituted fused aromatic ring or a fused aromatic ring containing, as a substituent, a divalent organic group having 1 to 20 carbon atoms and containing no hydroxy groups or organic groups represented by the general formulae (1); and Ar₂ is a different fused aromatic ring from Ar₁, and represents an unsubstituted fused aromatic ring or a fused aromatic ring containing, as a substituent, a divalent organic group having 1 to 20 carbon atoms and containing no hydroxy groups or organic groups represented by the general formulae (1).

A resin having a constitutional unit represented by the general formula (A-1) or (A-2) has a high-carbon-density fused aromatic ring introduced, and therefore, dissociation and recombination of carbon bonds by plasma irradiation are easily promoted, and a resist underlayer film having a diamond-like carbon structure can be formed.

Specific examples of the structures of Ar₁ and Ar₂ include the following structures (A-1a), but are not limited thereto.

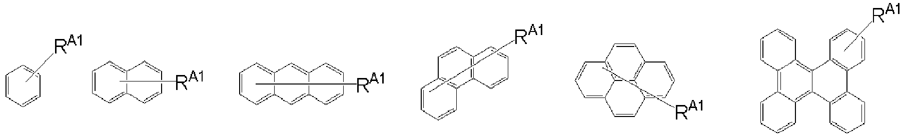

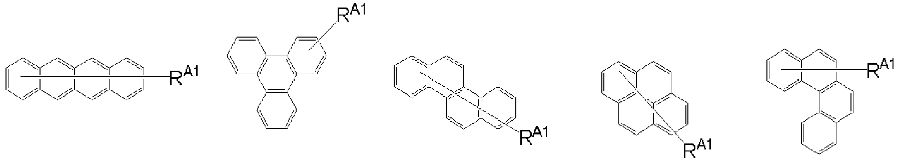

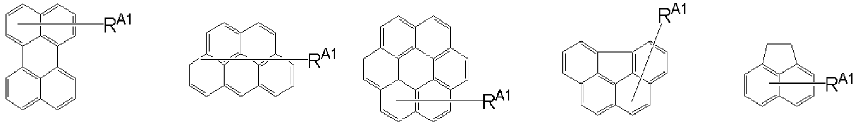

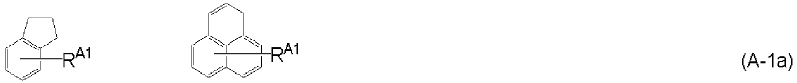

In the formulae (A-1a), R^{A1} represents a divalent organic group having 1 to 20 carbon atoms and containing no hydroxy groups or organic groups represented by the general formulae (1), or represents a hydrogen atom.

When the polymer has, as Ar₁ and Ar₂, any condensed aromatic ring represented by the general formulae (A-1a), it is possible to prepare a composition for forming a resist underlayer film excellent in solvent solubility. Furthermore, since a high-carbon-density fused aromatic ring is contained, dissociation and recombination of carbon bonds is easily promoted by plasma irradiation, and it is possible to form a resist underlayer film having a diamond-like carbon structure.

In the formulae (A-1a), R^{A1} preferably represents a hydrogen atom or a hydrocarbon group having 1 to 20 carbon atoms (and containing no hydroxy groups or organic groups represented by the general formulae (1)), more preferably a hydrogen atom, an alkyl group having 1 to 20 carbon atoms (and containing no hydroxy groups or organic groups represented by the general formulae (1)), a phenyl group, or a benzyl group, and further preferably a hydrogen atom.

When the Ar₁ and Ar₂ are groups each having the above-described group R^{A1}, solvent solubility can be further enhanced without degradation of dry etching resistance. Therefore, such groups are preferable.

From the viewpoints of solvent solubility and productivity of the aromatic ring-containing resin (A), examples of particularly favorable structures out of the structures represented by the general formulae (A-1a) include the following. 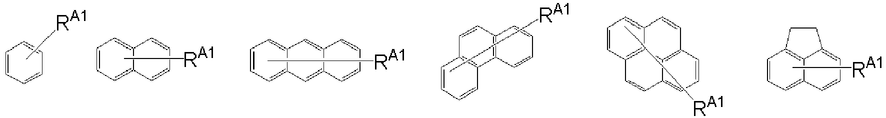 In the formulae, R^{A1} represents a divalent organic group having 1 to 20 carbon atoms and containing no hydroxy groups or organic groups represented by the general formulae (1), or represents a hydrogen atom.

The polymer having a structure represented by the above (A-1) may also be a copolymer having two repeating units represented by the following formulae (A-1x).

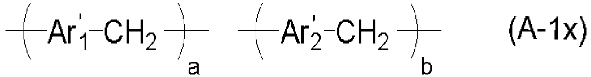

In the formulae, (A-1x), Ar₁' represents naphthalene, anthracene, phenanthrene, or pyrene; and Ar₂' has a structure different from that of Ar₁' , and has any structure selected from the formulae (A-1a). a+b is 100, 30 ≤ a ≤ 99, and 1 ≤ b ≤ 70.

In the formulae (A-1x), Ar₁' represents any of naphthalene, anthracene, phenanthrene, and pyrene, but from the viewpoint that dissociation and recombination of carbon bonds are easily promoted at the time of high temperature treatment under a nitrogen atmosphere and an amorphous carbon-like film can be formed, naphthalene and anthracene are preferable, and anthracene is further preferable. In addition, the Ar₂' in the formula (2) has a structure different from that of Ar₁' , and when Ar₁' is anthracene, Ar₂' is preferably naphthalene, phenanthrene, or pyrene from the viewpoints of etching resistance, solvent solubility, and productivity.

In the formulae (A-1x), the ranges of "a" and "b" are 30 ≤ a ≤ 99 and 1 ≤ b ≤ 70, and from the viewpoints of etching resistance and solvent solubility, preferably 50 ≤ a ≤ 80 and 20 ≤ b ≤ 50.

A polymer having two different kinds of repeating units randomly as in the formulae (A-1x) can further enhance solvent solubility, and therefore, is preferable.

In the general formula (A-2), one of Ar₁ and Ar₂ is preferably anthracene. By an anthracene structure being contained, dissociation and recombination of carbon bonds is easily promoted by plasma irradiation, and it is possible to form a resist underlayer film having a diamond-like carbon structure.

The resin having the constitutional units represented by the general formulae (A-1) and (A-1x) may have an end-capping group represented by the following general formula (W-1). Note that the following end-capping group is not contained in a repeating unit constituting the polymer. 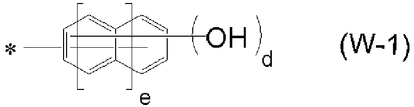 In the formula (W-1), "*" represents an attachment point to the constitutional unit represented by the formula (A-1) or the formula (A-2), "d" represents an integer of 1 to 9, and "e" represents an integer of 0 to 2.

When such an end-capping group is contained, the solvent solubility and substrate adhesiveness of the resin can be further enhanced.

In the formula (W-1), "d" represents an integer of 1 to 9 and "e" represents an integer of 0 to 2, and from the viewpoints of etching resistance, solvent solubility, and substrate adhesiveness, "d" is preferably 1 or 2 and "e" is preferably 0 or 1. When it is desired to improve etching resistance, "d" is preferably small and "e" is preferably large. When it is desired to improve solvent solubility and substrate adhesiveness, "d" is preferably large and "e" is preferably small.

The polymer having the constitutional units represented by the general formulae (A-1) and (A-2) preferably has a molecular weight of 300 to 5,000, more preferably 500 to 3,500 as measured by gel permeation chromatography in terms of polystyrene. When the molecular weight is 300 or more, the amount of sublimation products can be suppressed, and degradation of film thickness uniformity can be suppressed. When the molecular weight is 5,000 or less, the solvent solubility of the resin can be maintained, so that precipitation over time can be prevented, and therefore, such a molecular weight is preferable from the viewpoint of storage stability. In addition, since flowability is excellent, excellent filling property and excellent flatness can be realized. Furthermore, outgas during baking can be suppressed without the solubility of the polymer in an organic solvent being degraded.

### [First Method for Manufacturing Polymer]

A resin having the structure represented by the formula (A-1) as a repeating unit can be obtained, for example, by a polycondensation reaction, shown below, between a condensed aromatic ring compound represented by Ar₁ and an aldehyde. The Ar₁ in the following formulae is as defined above.

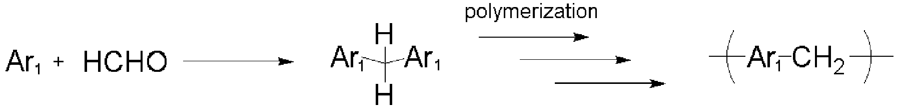

As each of the condensed aromatic ring compound or aldehyde compound, one kind of compound may be used in the polycondensation reaction, or two or more kinds may be used, and the compounds can be appropriately selected and combined in accordance with required properties.

A polycondensation reaction can be usually achieved in an organic solvent in the presence of an acid catalyst at room temperature or, as necessary, under cooling or heating. Examples of acid catalysts that can be used include: inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; and Lewis acids, such as aluminum trichloride, aluminum ethoxide, aluminum isopropoxide, boron trifluoride, boron trichloride, boron tribromide, tin tetrachloride, tin tetrabromide, dibutyltin dichloride, dibutyltin dimethoxide, dibutyltin oxide, titanium tetrachloride, titanium tetrabromide, titanium (IV) methoxide, titanium (IV) ethoxide, titanium (IV) isopropoxide, and titanium (IV) oxide.

Examples of the organic solvent used in the polycondensation reaction include: alcohols, such as methanol, ethanol, isopropyl alcohol, butanol, ethylene glycol, propylene glycol, diethylene glycol, glycerol, ethylene glycol monomethyl ether, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; aprotic polar solvents, such as dimethyl sulfoxide, N,N-dimethylformamide, and hexamethylphosphoric triamide; etc. One of these solvents can be used, or two or more kinds thereof can be used in mixture.

Examples of reaction methods include: a method in which a condensed aromatic ring compound, an aldehyde compound, and an acid catalyst are charged at once; a method in which a condensed aromatic ring compound and an aldehyde compound are dispersed or dissolved, and then an acid catalyst is added at once or diluted with a solvent and added dropwise; and a method in which an acid catalyst is dispersed or dissolved, and then a condensed aromatic ring compound and an aldehyde compound are added at once or diluted with a solvent and added dropwise. After completion of the reaction, the product may be used as it is for the composition of the present invention for forming an organic film, or the product may be diluted in an organic solvent in order to remove unreacted raw materials, the acid catalyst, etc. present in the system, and then may be subjected to liquid-liquid separation washing and collected.

The organic solvent used in the liquid-liquid separation washing is not particularly limited, as long as it is capable of dissolving the compound and being separated into two layers when mixed with water. Examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; and the like.

As the water used for washing in the liquid-liquid separation washing, generally, what is called deionized water or ultrapure water may be used. The washing may be performed once or more, preferably approximately once to five times, because washing ten times or more does not always produce the full washing effects thereof.

In the liquid-liquid separation washing, the washing may be performed with a basic aqueous solution to remove unreacted raw materials or acidic components in the system. Specific examples of the base contained in the basic aqueous solution include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove unreacted raw materials, metal impurities, or basic components in the system. Specific examples of the acid contained in the acidic aqueous solution include inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or acidic aqueous solution, washing with neutral water may be successively performed. This washing may be performed once or more, preferably approximately once to five times. As the neutral water, deionized water, ultrapure water, or the like mentioned above may be used. The washing may be performed once or more, but if the washing is not performed sufficiently, the basic components and the acidic components may not be removed in some cases. The washing is performed preferably approximately once to five times because washing ten times or more does not always produce the full washing effects.

Further, the reaction product after the liquid-liquid separation washing can also be collected as a powder by concentrating and drying the solvent or crystallizing the reaction product under reduced pressure or normal pressure. Alternatively, the reaction product can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, and degradation of the workability can be prevented; in addition, since the amount of the solvent is not excessive, the solution can be prepared economically.

The solvent in this event is not particularly limited, as long as it is capable of dissolving the polymer. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

### [Second Method for Manufacturing Polymer (Alternative Method 1)]

A resin having the structure represented by the formula (A-1) as a repeating unit can also be obtained by an alternative, second manufacturing method by a polymerization reaction using a raw material represented by Ar₁-CH₂-X. Ar₁ is as defined above, and X represents a hydroxy group, an alkoxy group having 1 to 4 carbon atoms, or a halogen group.

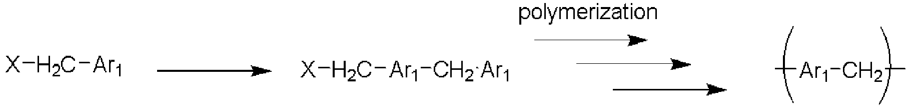

The polymerization reaction shown above is a polymerization reaction according to which the polymer can be obtained from the monomer alone. In the polycondensation reaction of the first manufacturing method, a common polymer has a repeating unit derived from monomers A and B due to a dehydration reaction or the like between molecules using the usual two types of monomers A and B. However, according to the above-described method for manufacturing a polymer, it is possible to synthesize a homopolymer with one kind of monomer. In the present invention, the second manufacturing method is preferable from the viewpoint of productivity.

### [First method for manufacturing polymer: monomers form repeating unit alternately]

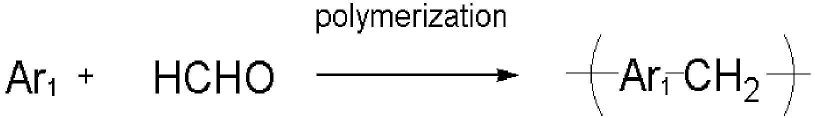

### [Second method for manufacturing polymer (alternative method 1): homopolymer of only monomer A]

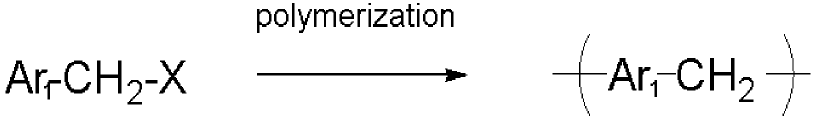

According to the reaction method shown above for synthesizing the polymer, when two monomers having a plurality of different fused aromatic rings (Ar₁ and Ar₂), for example, are used, a random polymer (A-1x), not having a specific repeating unit, can be synthesized by charging the monomer at once. Alternatively, a polymer having a block structure can also be synthesized by synthesizing a polymer with a monomer having Ar₁ in a first step, and then further charging a monomer having Ar₂ in a second step. These synthesis methods can be selected appropriately according to required performance and so forth.

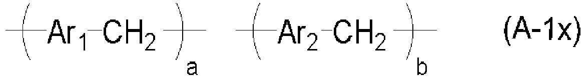

### [Two types of monomers: random type (charging at once)]

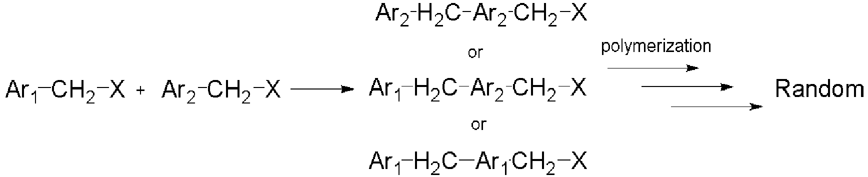

### [Two types of monomers: block type (charging in two steps)]

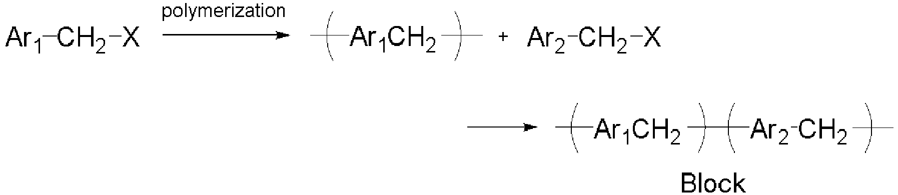

The polymer, represented by the formulae (A-1x), obtained by the above-described synthesis method contains two kinds of repeating units randomly, and therefore, it is possible to provide a resin having better solvent solubility.

Furthermore, in the second reaction method described above for synthesizing the polymer, it is also possible to introduce at once or during the reaction, as an end-capping unit, an aromatic component Arx (Arx not having a reactive unit) capable of reacting with the monomer. These methods for introducing the end-capping group can be selected appropriately by reaction rate and so forth. In the first polymerization method, the group can only be introduced to the ends due to the reactivity, but when this polymerization method is used, one molecule of the end-capping unit can be introduced to one molecule of the polymer. Therefore, when a polar group, such as a hydroxy group, for adjusting film-formability, adhesiveness, etc. is to be introduced in a case where the polymer is used as an end-capped resist underlayer film material, it is possible to aim at performance improvement with the minimum introduction amount, and the method is better in view of etching resistance. On the other hand, when the repeating unit structure of the polymer contains a hydroxy group or an organic group represented by one of the general formulae (1), many crosslinking group components are contained in the polymer, and therefore, dissociation/recombination of carbon bonds caused by plasma irradiation and a curing reaction occur competitively, and there is a risk of inhibiting modification to a film having excellent dry etching resistance.

### [End-capping: introduction during reaction]

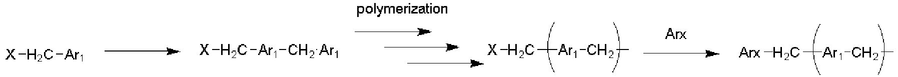

### [End-capping: charging at once]

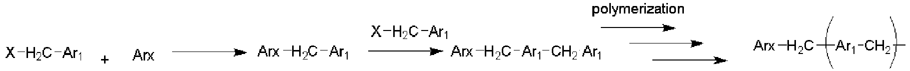

Examples of the aromatic component Arx include the following, and these aromatic rings may have thereon a substituent such as a vinyl group, an ethynyl group, an ethynylphenyl group, an allyl group, a propargyl group, an aryl group, an allyloxy group, and a propargyloxy group. From the viewpoint of providing etching resistance and solvent solubility, the substituent preferably has a naphthalene ring, a fluorene structure, or a carbazole structure.

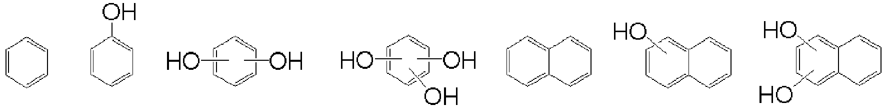

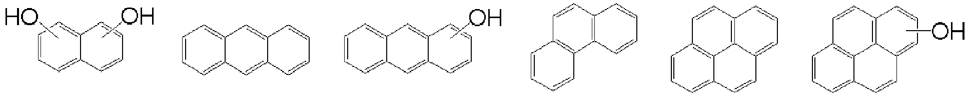

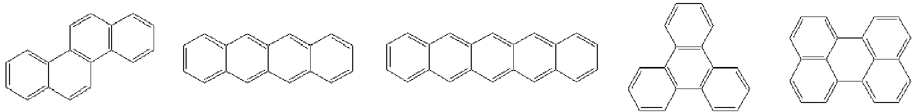

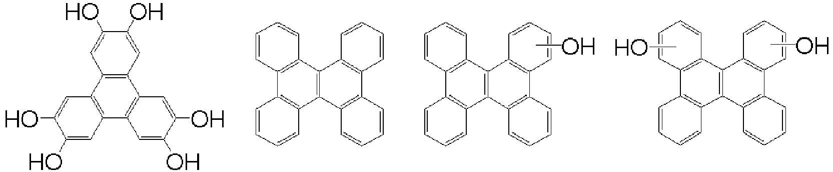

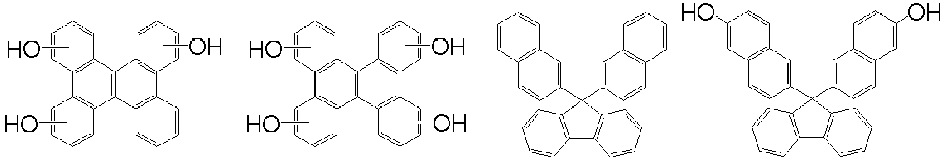

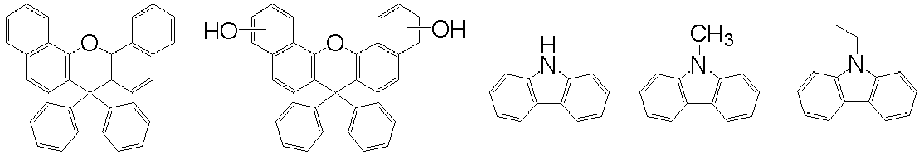

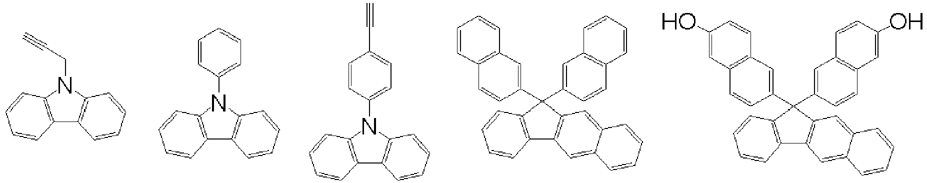

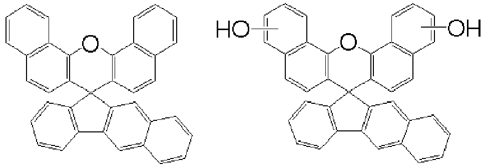

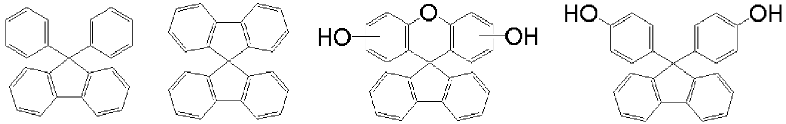

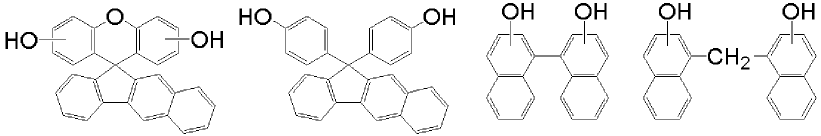

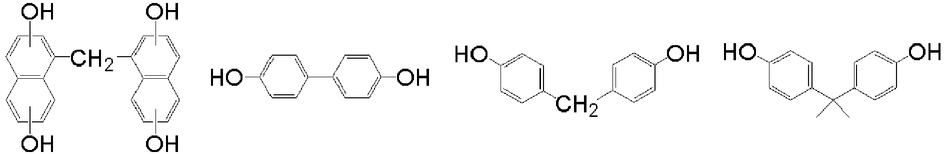

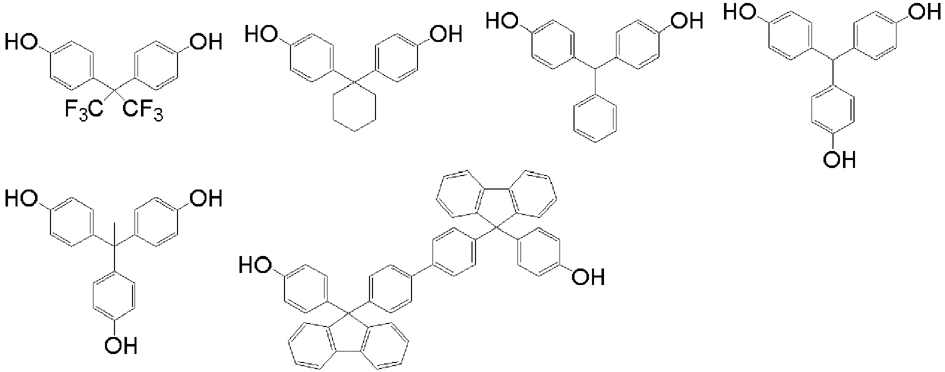

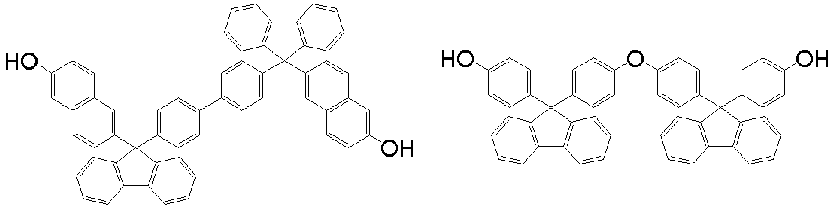

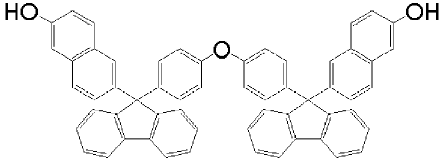

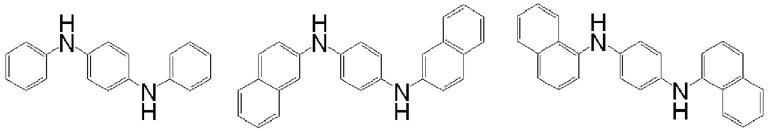

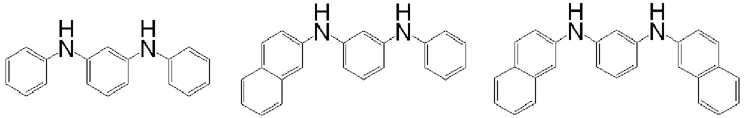

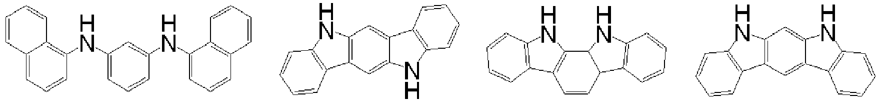

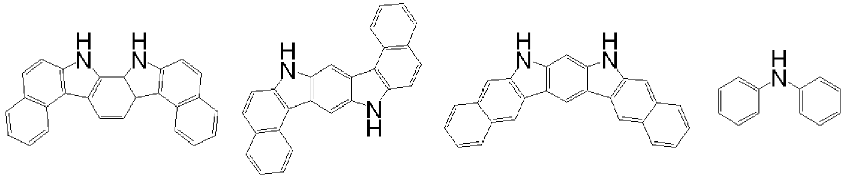

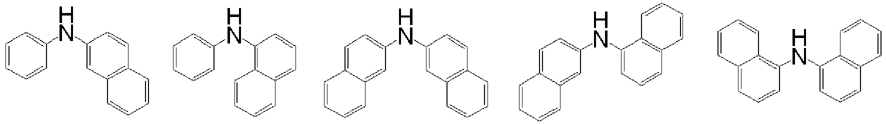

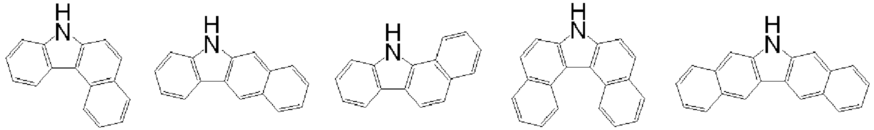

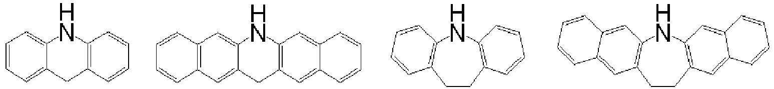

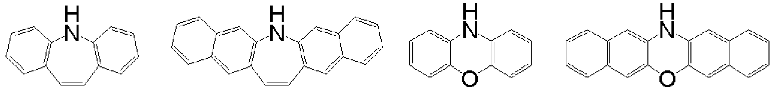

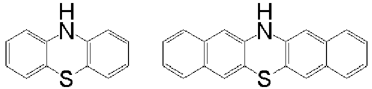

### [Third Method for Manufacturing Polymer (Example of Method for Manufacturing Resin Having Structure Represented by Formula (A-2) as Repeating Unit)

### (Alternative Method 2)]

A polymer (resin) having the structure represented by the formula (A-2) as a repeating unit can be obtained by a polymerization reaction, shown below, using a condensed aromatic ring compound represented by Ar₁ and a raw material represented by X-CH₂-Ar₂-CH₂-X. 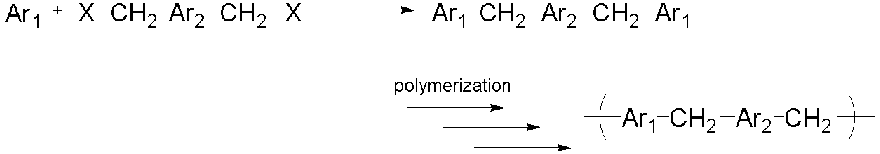 Ar₁ and Ar₂ are as defined above, and X represents a hydroxy group, an alkoxy group having 1 to 4 carbon atoms, or a halogen group.

The polymer (the resin containing, as a repeating unit, the structure represented by the formula (A-2)) obtained by the third manufacturing method is a polymer having a repeating unit in which the condensed aromatic ring compound and X-CH₂-Ar₂-CH₂-X alternate.

### [Monomers A and B alternately forming repeating unit]

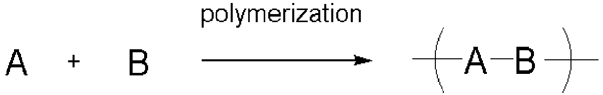

In the second and third synthesis reactions of the polymer, the same reaction method and collection method as those described in the explanation of the first manufacturing method can be carried out, the only difference from the first manufacturing method being the monomer used.

### (Constitutional Units: A-3 and A-4)

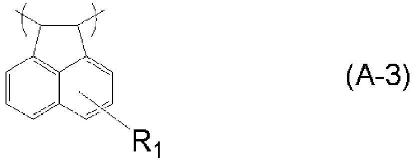

In the general formula (A-3), R₁ represents a hydrogen atom, a halogen atom, or a linear, branched, or cyclic hydrocarbon group having 1 to 20 carbon atoms.

In the general formula (A-3), R₁ is preferably a hydrogen atom from the viewpoint of availability of raw materials. 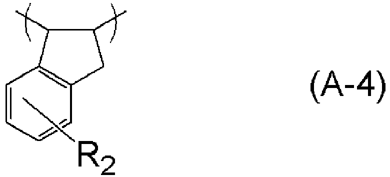 In the general formula (A-4), R₂ represents a hydrogen atom, a halogen atom, or a linear, branched, or cyclic hydrocarbon group having 1 to 20 carbon atoms.

In the general formula (A-4), R₂ is preferably a hydrogen atom from the viewpoint of availability of raw materials.

Resins having the constitutional unit represented by the general formulae (A-3) and (A-4) have a high-carbon-density aromatic ring introduced, and therefore, dissociation and recombination of carbon bonds are easily promoted by plasma irradiation, and it is possible to form a resist underlayer film having a diamond-like carbon structure.

Furthermore, the polymer used in the present invention may be a resin containing both of the constitutional units represented by the general formulae (A-3) and (A-4), and moreover, may further contain a resin having a constitutional unit represented by the following general formula (A-4a).

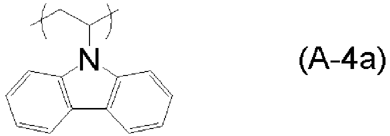

Preferable examples of the resin containing the general formulae (A-3), (A-4), and (A-4a) include resins having a structure shown in the following general formulae (1C). 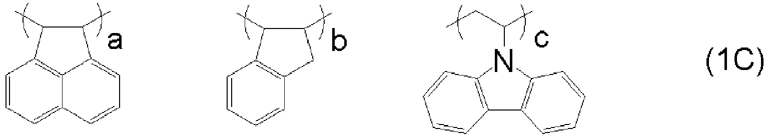 In the general formulae (1C), "a", "b", and "c" each satisfy a + b + c = 1, 0.5 ≤ a ≤ 0.9, 0.1 ≤ b + c ≤ 0.5.

In the general formulae (1C), "a", "b", and "c" each preferably satisfy a + b + c = 1, 0.5 ≤ a ≤ 0.9, and 0.1 ≤ b+c ≤ 0.5, and more preferably satisfy 0.7 ≤ a ≤ 0.9 and 0.1 ≤ b + c ≤ 0.3.

The specific structure of the resin having structures represented by the general formulae (A-3) and (A-4) is not particularly limited as long as any of these structures are contained in the resin, and a mixed composition of a resin having the constitutional unit represented by the general formula (A-3) and a resin having the constitutional unit represented by the general formula (A-4) is possible, and a copolymer of a resin having the constitutional unit represented by the general formula (A-3) and a resin having the constitutional unit represented by the general formula (A-4) is possible.

The polymer can be obtained by polymerizing a polymerizable monomer by a known method. When obtaining the polymer, it is also possible to synthesize the polymer by polymerizing monomers protected by a protecting group as necessary, and then performing a deprotection reaction as necessary. Reaction methods for obtaining the polymer are not particularly limited, and it is possible to employ a method such as radical polymerization and cationic polymerization and select the method appropriately depending on the reactivity of the monomer and so forth.

When radical polymerization is to be employed, there is a method of mixing a monomer having a polymerizable unsaturated bond and adding a radical initiator into the solvent to perform thermal polymerization. The polymer can be thus obtained. Various polymerization conditions can be selected in accordance with the monomers to be used, the target molecular weight, etc. Specific examples of the solvent to be used in the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, and butyl acetate. Examples of the polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, and lauroyl peroxide. As a chain transfer agent, it is also possible to add, upon polymerization, a thiol such as octanethiol and 2-mercaptoethanol. The polymerization reaction can be performed preferably at a temperature of 40°C to the boiling point of the reaction solvent. The reaction time can be 0.5 to 100 hours, preferably 1 to 48 hours.

When cationic polymerization is to be employed, there is a method of mixing a monomer having a polymerizable unsaturated bond and adding a cationic polymerization initiator to perform polymerization. The polymer can be thus obtained. Various polymerization conditions can be selected in accordance with the monomers to be used, the target molecular weight, etc. Specific examples of the solvent to be used in the polymerization include hexane, heptane, octane, toluene, methylene chloride, 1,2-dichloroethane, ethyl ether, butyl ether, etc. As a catalyst to be used as the cationic polymerization initiator, it is possible to use a protonic acid, such as hydrochloric acid, sulfuric acid, perchloric acid, trifluoroacetic acid, methanesulfonic acid, trifluoromethanesulfonic acid, chlorosulfonic acid, and fluorosulfonic acid; a Lewis acid, such as boron trifluoride, aluminum chloride, titanium tetrachloride, stannic chloride, and ferric chloride; etc. When a Lewis acid is to be used as a catalyst, the presence of a source of proton supply, such as acid, water, or alcohol, at about the same number of moles as the catalyst, improves cationic polymerization activity. Therefore, such a material can also be contained. The polymerization reaction is not particularly limited as long as the temperature is a temperature at which the reaction progresses, but it is preferable to perform the reaction while heating at - 10°C to the boiling point of the reaction solvent. The reaction time can be 0.5 to 100 hours, preferably 1 to 48 hours.

The method for obtaining the polymer is preferably cationic polymerization. In radical polymerization, terminal structures containing heteroatoms originating from a radical initiator are introduced into the polymer, and the heteroatoms, such as oxygen and nitrogen, other than carbon, degrade etching resistance. In cationic polymerization, however, such inconvenience does not arise. Therefore, the method for obtaining the polymer is preferably cationic polymerization, from the viewpoint of etching resistance.

The resin having any of the constitutional units represented by the general formulae (A-3) and (A-4) preferably has a molecular weight of 300 to 5,000, more preferably 1,000 to 4,500, and further preferably 2,000 to 4000, as measured by gel permeation chromatography in terms of polystyrene. When the molecular weight is 300 or more, the amount of sublimation products can be suppressed, and degradation of film thickness uniformity can be suppressed. When the molecular weight is 5,000 or less, the solvent solubility of the resin can be maintained, so that precipitation over time can be prevented, and therefore, such a molecular weight is preferable from the viewpoint of storage stability. In addition, since flowability is excellent, excellent filling property and excellent flatness can be realized. Furthermore, outgas during baking can be suppressed without the solubility of the polymer in an organic solvent being degraded.

### (Constitutional Unit: A-5)

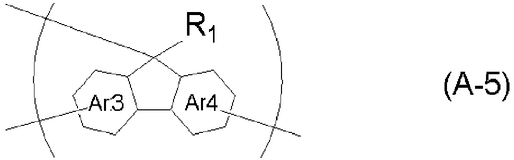

In the general formula (A-5), R₁ represents a hydrogen atom or a monovalent organic group having 1 to 50 carbon atoms and containing no hydroxy groups or organic groups represented by the general formulae (1); and Ar3 and Ar4 each represent an unsubstituted benzene ring or naphthalene ring.

Examples of the partial structure constituted by Ar3 and Ar4 in the general formula (A-5) include the following. Among the following, fluorene and benzofluorene structures are preferable from availability of raw materials.

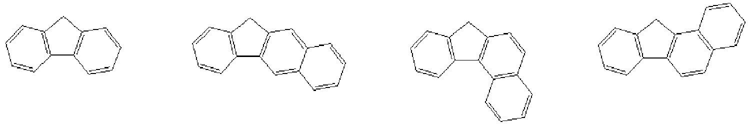

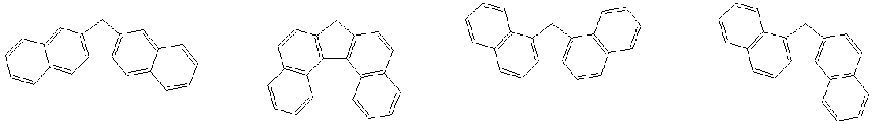

The polymer preferably further has a partial structure represented by the following general formula (A-5a).

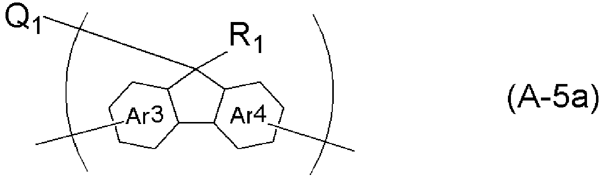

In the general formula (A-5a), Q₁ represents an alkyloxy group having 1 to 10 carbon atoms or an organic group having one or more aromatic rings and optionally having a substituent other than a hydroxy group and an organic group represented by one of the general formulae (1); R₁ represents a hydrogen atom or a monovalent organic group having 1 to 50 carbon atoms and containing no hydroxy groups or organic groups represented by the general formulae (1); and Ar3 and Ar4 each represent an unsubstituted benzene ring or naphthalene ring.

Examples of the organic group having one or more aromatic rings in the Q₁ in the general formula (A-5a) include the following, and the organic group may have a substituent, such as an alkyl group, an aryl group, or an ethynylphenyl group, on the aromatic rings. From the viewpoint of providing etching resistance and solvent solubility, the organic group preferably has a naphthalene ring, a fluorene structure, or a carbazole structure.

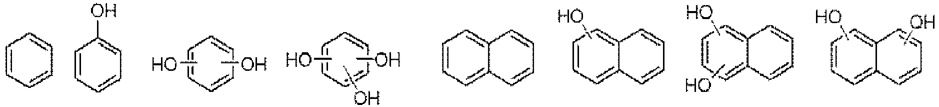

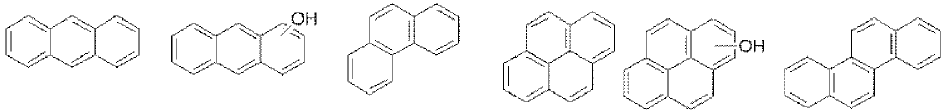

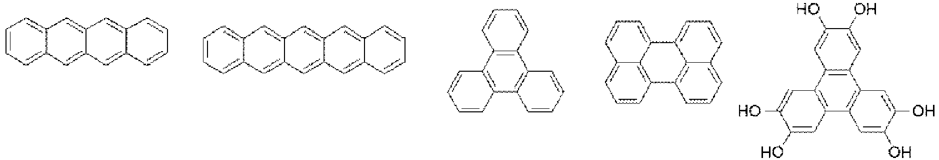

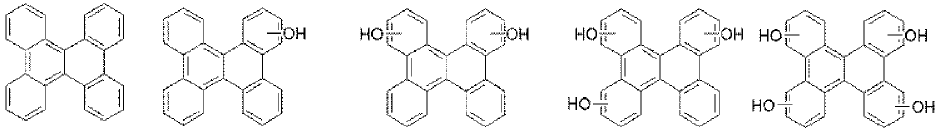

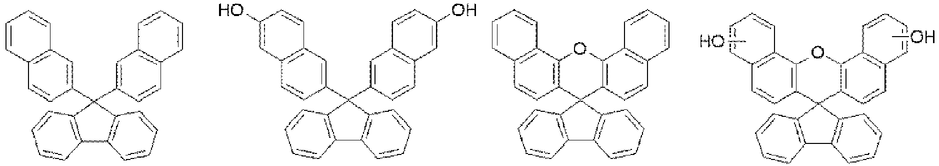

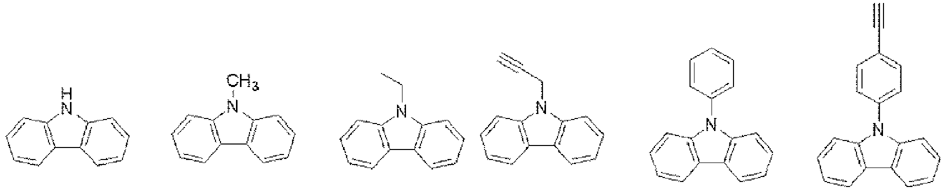

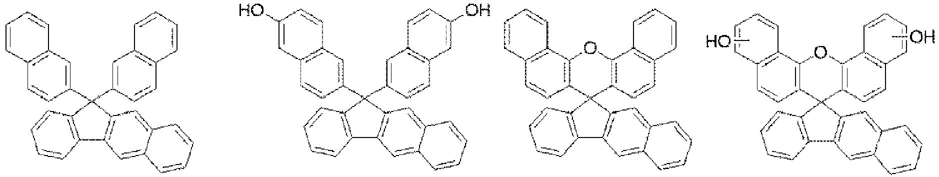

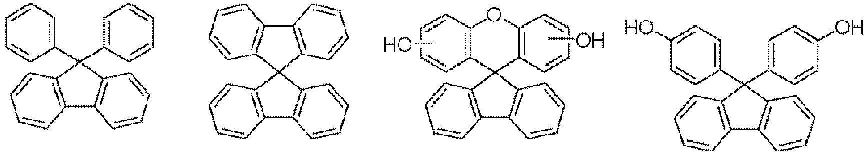

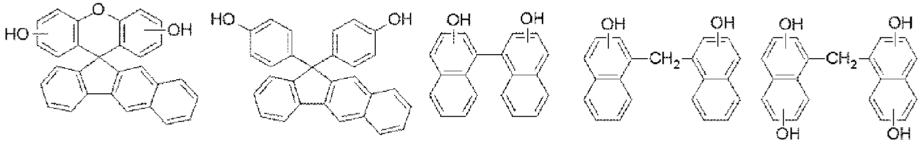

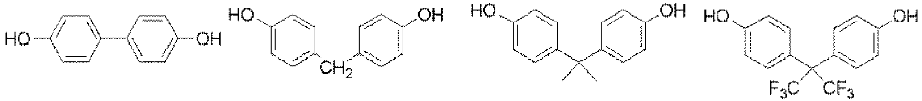

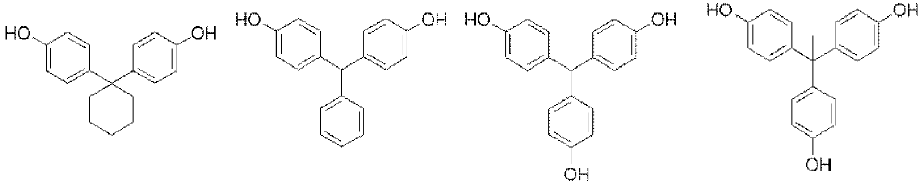

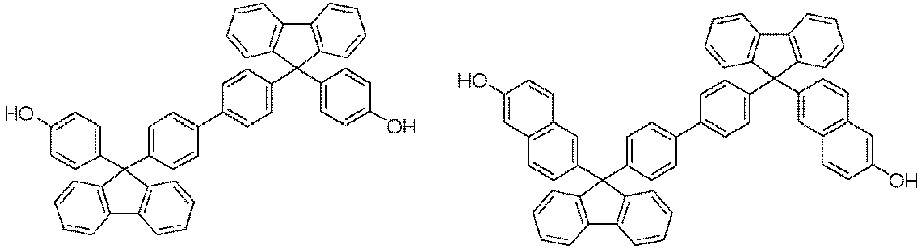

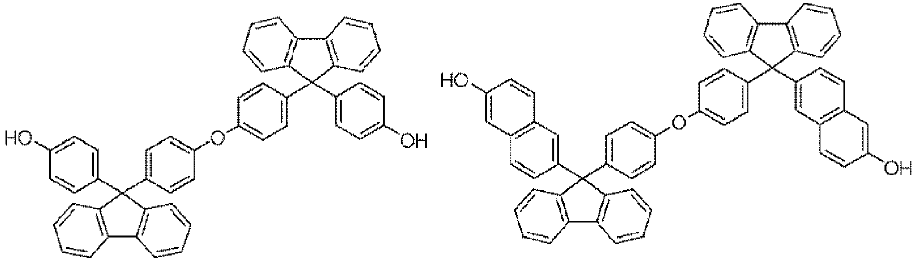

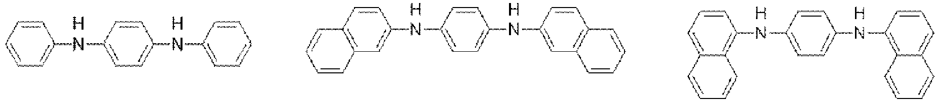

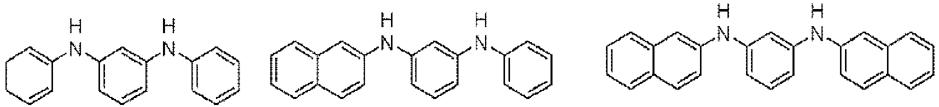

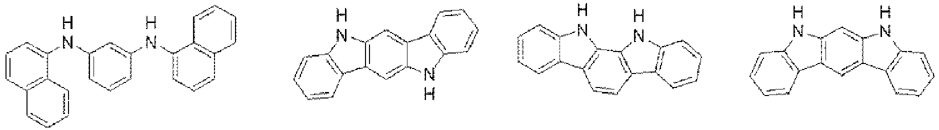

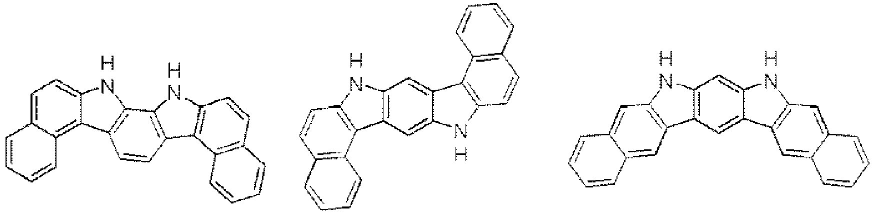

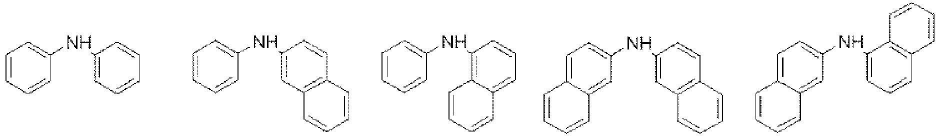

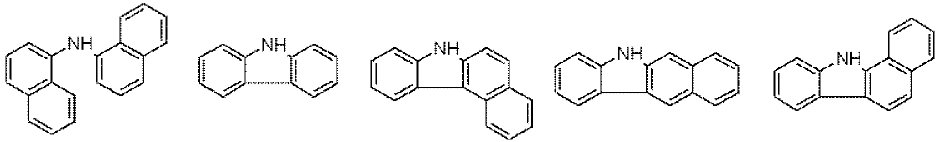

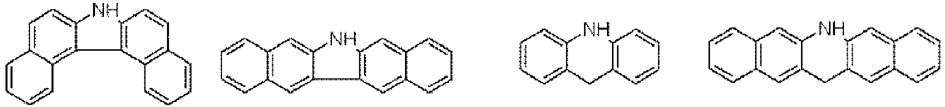

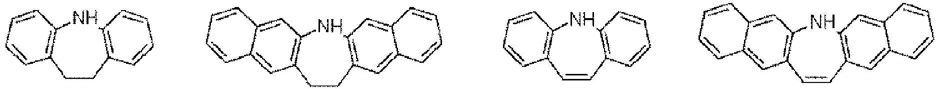

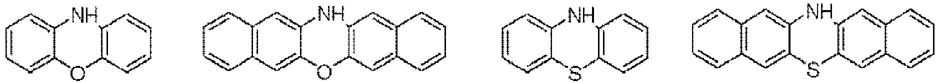

In the present invention, the polymer preferably further has a partial structure represented by (A-5b). 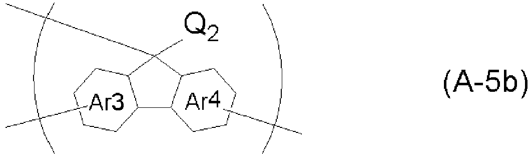 In the general formula (A-5b), Q₂ represents a hydrogen atom or a monovalent organic group having 1 to 50 carbon atoms and containing no hydroxy groups or organic groups represented by the general formulae (1); and Ar3 and Ar4 are as defined above.

Examples of the Q₂ in the general formula (A-5b) include alkyl groups having 1 to 10 carbon atoms, the following structures, etc. When Q₂ has an aromatic ring, the aromatic ring may have thereon a substituent such as an alkyl group having 1 to 10 carbon atoms, an alkyloxy group having 1 to 10, an ethynylphenyl group, or an aryl group. In particular, an aromatic ring having a naphthyl group is preferable from the viewpoint of providing etching resistance and solvent solubility.

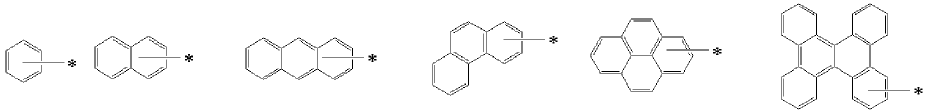

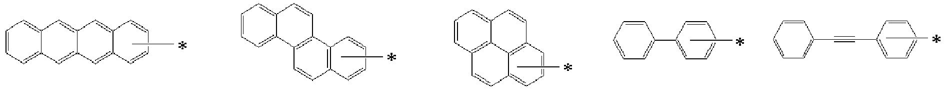

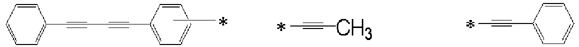

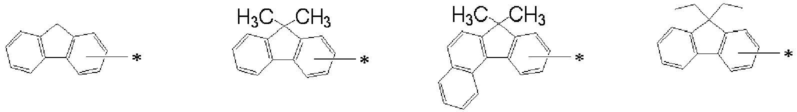

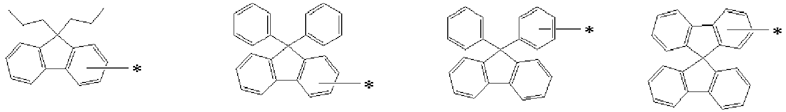

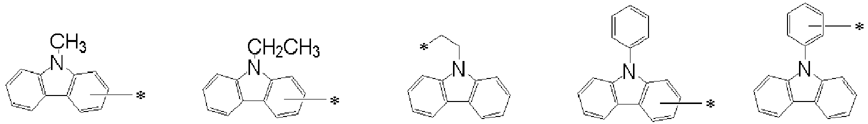

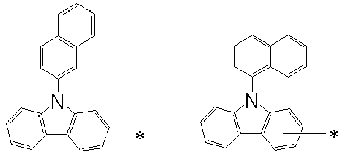

As the method for synthesizing the polymer, it is possible to use methods disclosed in paragraphs [0059] to [0079] of JP7082087B2.

The resin having the constitutional unit represented by the general formula (A-5) preferably has a molecular weight of 300 to 5,000, more preferably 600 to 4,000, as measured by gel permeation chromatography in terms of polystyrene. When the molecular weight is 300 or more, the amount of sublimation products can be suppressed, and degradation of film thickness uniformity can be suppressed. When the molecular weight is 5,000 or less, the solvent solubility of the resin can be maintained, so that precipitation over time can be prevented, and therefore, such a molecular weight is preferable from the viewpoint of storage stability. In addition, since flowability is excellent, excellent filling property and excellent flatness can be realized. Furthermore, outgas during baking can be suppressed without the solubility of the polymer in an organic solvent being degraded.

### [(B) Organic Solvent]

The organic solvent that can be used in the above-described composition for forming a resist underlayer film is not particularly limited as long as it is capable of dissolving the polymer (A), and an organic solvent also capable of dissolving a crosslinking agent, a surfactant, an acid generator, a plasticizer, which will be described later, is preferable.

Specifically, for example, a solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

It is desirable to adjust the amount of the organic solvent to be contained in accordance with the set film thickness of the resist underlayer film, and usually, the amount is 100 to 50,000 parts by mass based on 100 parts by mass of the polymer (A).

### [(B-1) High-Boiling-Point Solvent]

In the above-described composition for forming a resist underlayer film, the organic solvent (B) may be a mixture of one or more kinds of organic solvent having a boiling point of lower than 180°C and one or more kinds of organic solvent having a boiling point of 180°C or higher (hereinafter, referred to as "high-boiling-point solvent (B-1)").

Specific examples of organic solvents having a boiling point of lower than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

The high-boiling-point solvent (B-1) is not particularly limited to hydrocarbons, alcohols, ketones, esters, ethers, or chlorine-based solvents as long as the solvent is capable of dissolving the components of the composition for forming a resist underlayer film used in the present invention. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B-1) may be selected suitably from the solvents above, for example, depending on the temperature at which the above-described composition for forming a resist underlayer film is heat-treated, etc. The boiling point of the high-boiling-point solvent (B-1) is preferably 180°C to 300°C, further preferably 200°C to 300°C. When the boiling point is as described, sufficient thermal flowability can be achieved at the time of film formation, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent (B-1) is used, the amount to be blended is preferably 1 to 200 parts by mass, more preferably 1 to 100 parts by mass per 100 parts by mass of the resin represented by the general formula (A). When the contained amount is as described, there are no risks that sufficient thermal flowability cannot be imparted at the time of baking due to the contained amount being too small or that the solvent remains in the film due to the contained amount being too large and leads to degradation of physical properties, such as etching resistance, of the film. Therefore, such an amount is preferable.

### [(C) Crosslinking Agent]

To increase curability and enhance dry etching resistance, a crosslinking agent (C) can also be added to the above-described composition for forming a resist underlayer film.

Specifically, as the crosslinking agent (C), a compound having a structure represented by the following general formula (C-1) is particularly preferable.

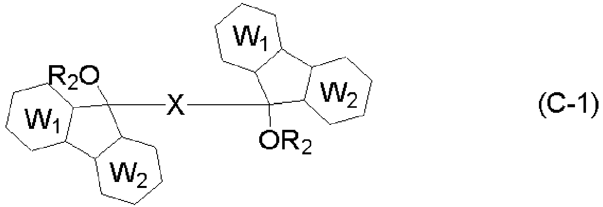

In the general formula (C-1), W₁ and W₂ each represent a benzene ring or naphthalene ring optionally having a substituent; R₂ represents a hydrogen atom or a monovalent organic group having 1 to 20 carbon atoms; and X represents any group represented by the following general formulae (2).

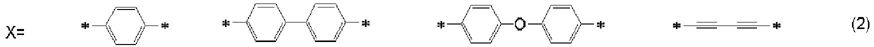

When the crosslinking agent (C) is contained, the crosslinking density and hardness of the resist underlayer film can be enhanced further without degrading the dry etching resistance of the composition for forming a resist underlayer film.

The crosslinking agent (C) preferably satisfies 1.00 ≤ Mw/Mn ≤ 1.25, where Mw is a weight-average molecular weight and Mn is a number-average molecular weight measured by gel permeation chromatography in terms of polystyrene.

When the molecular weight and the dispersity of the crosslinking agent are as described above, the thermal flowability of the composition for forming a resist underlayer film is excellent, and therefore, when the crosslinking agent is added to a resist underlayer film material, it is possible to form a resist underlayer film that can not only fill well a fine structure formed on a substrate but also achieve flatness across the entire substrate.

In addition, the crosslinking agent (C) is not particularly limited, and various known crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). When the crosslinking agent is added, the added amount is preferably 5 to 100 parts by mass, more preferably 10 to 50 parts by mass relative to 100 parts by mass of the resin represented by the general formula (A).

Specific examples of the melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethyleneurea, alkoxy- and/or hydroxy-substituted derivatives thereof, and partial self-condensates thereof. Specific examples of the β-hydroxyalkylamide-based crosslinking agents include N,N,N',N'-tetra(2-hydroxyethyl)adipic acid amide. Specific examples of the isocyanurate-based crosslinking agents include triglycidyl isocyanurate and triallyl isocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (C-2).

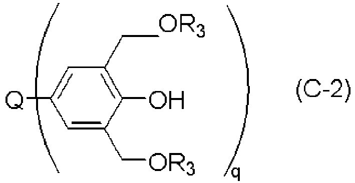

In the formula, Q represents a single bond or a q-valent hydrocarbon group having 1 to 20 carbon atoms. R₃ represents a hydrogen atom or a methyl group. "q" represents an integer of 1 to 5.

The Q in the general formula (C-2) represents a single bond or a hydrocarbon group having a valency of "q" and having 1 to 20 carbon atoms. "q" represents an integer of 1 to 5, more preferably 2 or 3. When Q is a q-valent hydrocarbon group having 1 to 20 carbon atoms, Q is obtained by removing "q" hydrogen atoms from a hydrocarbon having 1 to 20 carbon atoms. More specific examples of the hydrocarbon having 1 to 20 carbon atoms in this case include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

The R₃ in the general formula (C-2) represents a hydrogen atom or a methyl group, preferably a methyl group.

When the compound represented by the general formula (C-2) is contained as a crosslinking agent (C), the denseness of the film can be enhanced. This makes it possible to enhance further the heat resistance of the composition for forming a resist underlayer film.

Specific examples of the compound represented by the general formula (C-2) include the following compounds, but are not limited thereto. In the following formulae, R₃ is as defined above. Examples where "q" is 3 and R₃ is a hydrogen atom or a methyl group are preferable from the viewpoints of enhancing curability and film thickness uniformity and reducing sublimation products, and a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are particularly preferable.

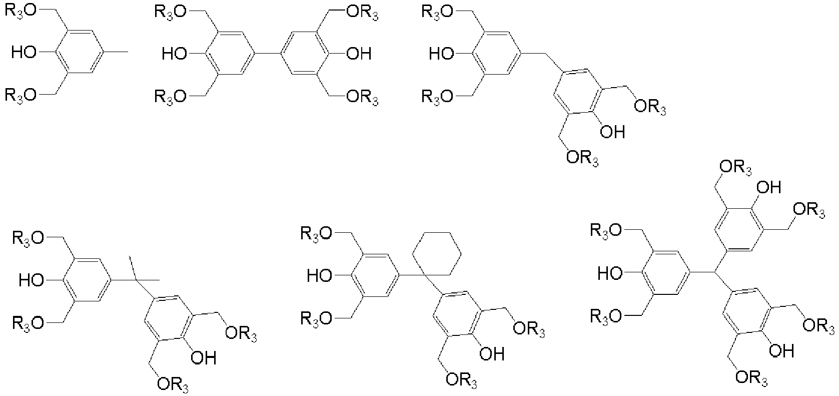

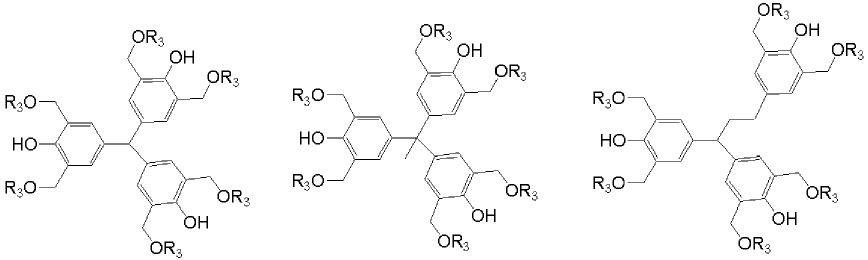

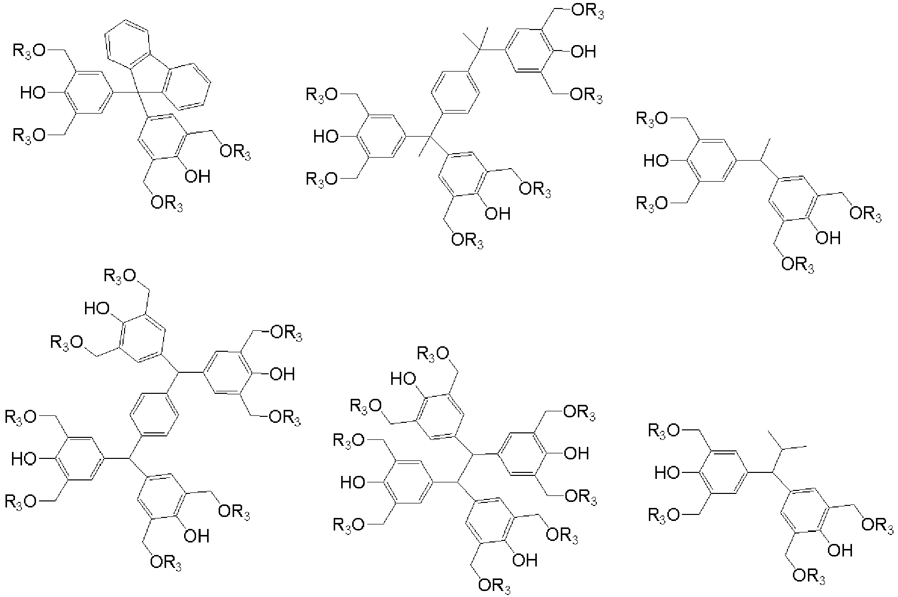

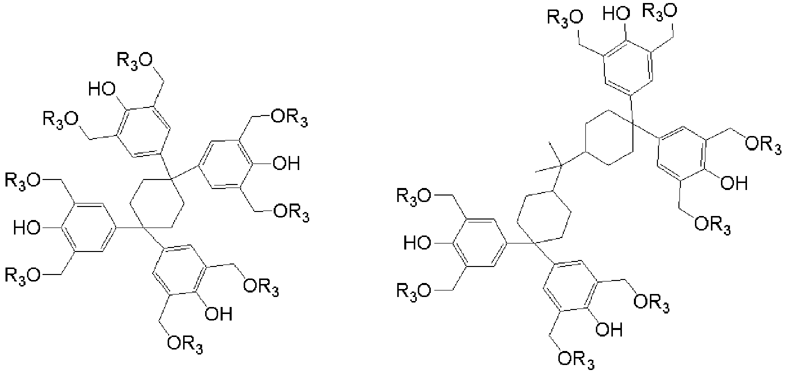

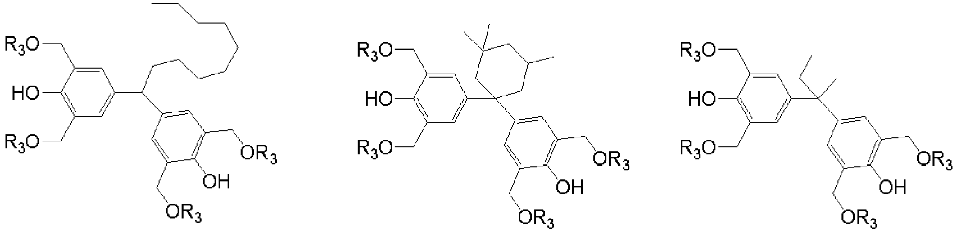

One kind of the crosslinking agent (C) can be used, or two or more kinds thereof can be used in combination. The amount of the crosslinking agent (C) to be contained is preferably 5 mass% to 100 mass%, more preferably 10 mass% to 50 mass% based on 100 parts by mass of the polymer (A). When the added amount is 5 mass% or more, a crosslinking reaction with the polymer (A) is promoted and a dense film excellent in curability is formed, and therefore, it is possible to form a resist underlayer film excellent in heat resistance, dry etching resistance, and film thickness uniformity. Meanwhile, when the added amount is 100 mass% or less, it is possible to suppress the generation of sublimation products that accompanies slowdown of a crosslinking reaction between the polymer (A) and the crosslinking agent (C), and it is possible to reduce the generation of sublimation products and the degradation of film thickness uniformity.

### [(D) Surfactant]

A surfactant (D) may be contained in the above-described composition for forming a resist underlayer film in order to improve coating property in spin-coating. Examples of the surfactant include those disclosed in paragraphs [0142] to [0147] of JP2009-269953A. When the surfactant is contained, the contained amount is preferably 0.001 to 20 parts by mass, more preferably 0.01 to 10 parts by mass per 100 parts by mass of the polymer (A).

### [(E) Acid Generator]

An acid generator (E) that can be contained in the above-described composition for forming a resist underlayer film can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When the acid generator is contained, the contained amount is preferably 0.05 to 50 parts by mass, more preferably 0.1 to 10 parts by mass relative to 100 parts by mass of the polymer (A).

### [(F) Plasticizer]

A plasticizer (F) may be contained in the above-described composition for forming a resist underlayer film in order to improve further the thermal flowability. The plasticizer is not particularly limited, and various known plasticizers can be widely used. Examples of the plasticizer include low molecular weight compounds, such as phthalate esters, adipate esters, phosphate esters, trimellitate esters, and citrate esters; and polymers, such as polyether-based polymers, polyester-based polymers, and polyacetal-based polymers disclosed in JP2013-253227A. When the plasticizer is contained, the contained amount is preferably 5 to 500 parts by mass, more preferably 10 to 200 parts by mass per 100 parts by mass of the polymer (A).

Besides the above-described additives, it is also possible to add an additive for further enhancing thermal flowability (flowability accelerator) to the above-described composition for forming a resist underlayer film. The additive is not particularly limited as long as it contributes to the enhancement of thermal flowability and imparts filling property and planarizing property. For example, it is preferable to use a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a). 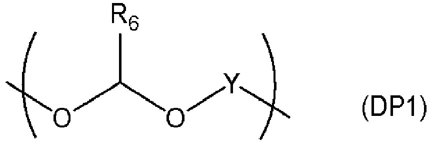 In the formula, R₆ represents a hydrogen atom or a saturated or unsaturated monovalent organic group having 1 to 30 carbon atoms, the organic group optionally being substituted. Y represents a saturated or unsaturated divalent organic group having 2 to 30 carbon atoms. 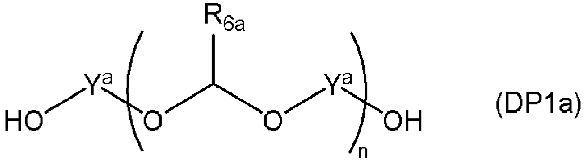 In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Patterning Process>

The present invention also provides, as a patterning process according to a two-layer resist process using the above-described composition for forming a resist underlayer film, a patterning process including:
forming a resist underlayer film on a substrate to be processed by the inventive method for forming a resist underlayer film;
forming a resist upper layer film on the resist underlayer film by using a photoresist material;
subjecting the resist upper layer film to pattern exposure and then to development with a developer to form a pattern in the resist upper layer film;
transferring the pattern to the resist underlayer film by dry etching while using the resist upper layer film having the formed pattern as a mask; and
processing the substrate to be processed while using the resist underlayer film having the formed pattern as a mask to form the pattern in the substrate to be processed.

The resist upper layer film in the two-layer resist process described above is preferably a photosensitive organic metal oxide film. The photosensitive organic metal oxide film exhibits etching resistance with respect to oxygen-based gas; therefore, the dry etching of the resist underlayer film that is performed while using the resist upper layer film as a mask in the two-layer resist process is preferably performed by using an etching gas mainly containing an oxygen-based gas.

The present invention also provides, as a patterning process using a three-layer resist process using the above-described composition for forming a resist underlayer film, a patterning process for forming a pattern in a substrate to be processed, including the steps of:
(I-1) forming a resist underlayer film on a substrate to be processed by the inventive method for forming a resist underlayer film;
(I-2) forming a resist middle layer film on the resist underlayer film;
(I-3) forming a resist upper layer film on the resist middle layer film by using a photoresist material;
(I-4) subjecting the resist upper layer film to pattern exposure and then to development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.

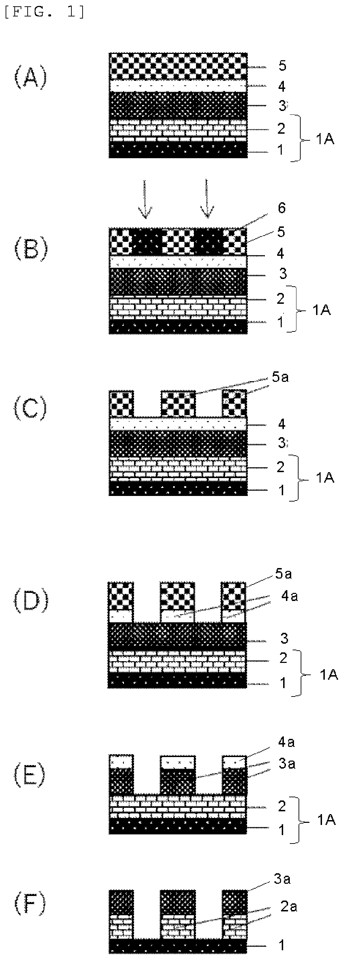

With reference to FIG. 1, an example of a patterning process according to a three-layer resist process will be described. Firstly, as shown in FIG. 1(A), a resist underlayer film 3 is formed by the inventive method for forming a resist underlayer film on a layer 2 to be processed of a substrate 1A to be processed, including a support substrate 1 and the layer 2 to be processed formed thereon, a resist middle layer film 4 is formed on the resist underlayer film 3 by using a resist middle layer film material, and a resist upper layer film 5 is formed on the resist middle layer film 4 by using a photoresist material. Subsequently, as in FIG. 1(B), an exposure portion 6 is formed in the resist upper layer film 5 by pattern exposure. Then, the exposure portion 6 is developed with a developer to form a resist upper layer film pattern 5a in the resist upper layer film 5 as in FIG. 1(C). Subsequently, as in FIG. 1(D), a silicon-containing resist middle layer film pattern 4a is transferred to the resist middle layer film 4 by dry etching while using the resist upper layer film 5 having the formed pattern 5a as a mask. Subsequently, as in FIG. 1(E), a resist underlayer film pattern 3a is transferred to the resist underlayer film 3 by dry etching while using the resist middle layer film 4 having the transferred pattern 4a as a mask. Then, as in FIG. 1(F), the layer 2 to be processed of the substrate 1A to be processed is processed while using the resist underlayer film 3 having the formed pattern 3a as a mask to form a pattern 2a on the substrate 1 to be processed.

The silicon-containing resist middle layer film in the three-layer resist process exhibits etching resistance with respect to an oxygen-based gas. Therefore, the dry etching of the resist underlayer film that is performed while using the silicon-containing resist middle layer film as a mask in the three-layer resist process is preferably performed using an etching gas mainly containing an oxygen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is to be cross-linked by an acid or heat.

In addition, the present invention provides a patterning process by way of a four-layer resist process using such a composition for forming a resist underlayer film, the patterning process including the steps of:
forming a resist underlayer film on a substrate to be processed by using the inventive method for forming a resist underlayer film;
forming a silicon-containing resist middle layer film on the resist underlayer film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then to development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the transferred pattern as a mask; and
processing the substrate to be processed while using the resist underlayer film having the formed pattern as a mask, thereby forming the pattern in the substrate to be processed.

Alternatively, an inorganic hard mask may be formed instead of the silicon-containing resist middle layer film. In this case, a semiconductor device circuit pattern can be formed on a substrate, at least, by:
forming a resist underlayer film on a body to be processed by using the composition of the present invention for forming a resist underlayer film;
forming an inorganic hard mask selected from a silicon oxide film, a silicon nitride film, and a silicon oxynitride film on the resist underlayer film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the resist underlayer film while using the inorganic hard mask having the formed pattern as a mask; and
furthermore, etching the body to be processed while using the resist underlayer film having the formed pattern as a mask to form the pattern in the body to be processed.

As described above, when the inorganic hard mask is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300°C to 500°C. Thus, the resist underlayer film formed by spin-coating and the inorganic hard mask formed by the CVD method or the ALD method can be combined.

A photoresist film may be formed on the inorganic hard mask as the resist upper layer film, as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the resist upper layer film is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the resist upper layer film is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a highfrequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the resist underlayer film is etched while using the obtained silicon-containing resist middle layer film pattern or inorganic hard mask pattern as a mask. The etching of the resist underlayer film is preferably performed using an etching gas mainly containing an oxygen-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained by the inventive method for forming a resist underlayer film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate (support substrate), and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

### EXAMPLES

The present invention is specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### Synthesis Examples: Synthesis of Polymer (A)

Each of polymers (A1) to (A13) were synthesized according to the following procedures. For the synthesis of the polymers (A1) to (A6) and the polymers (A11) to (A13), the compound group b ((b1) to (b10)) shown below was used.

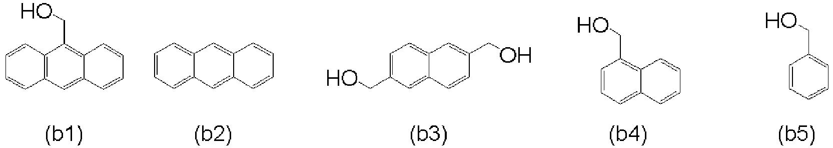

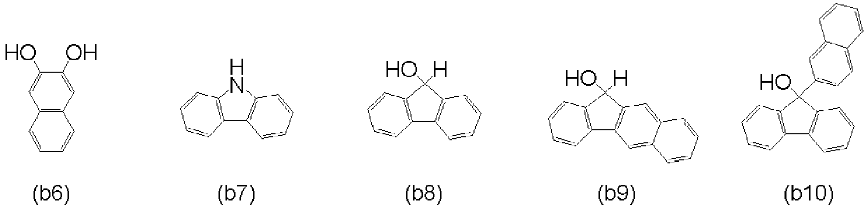

### [Synthesis Example 1] Synthesis of Polymer (A1)

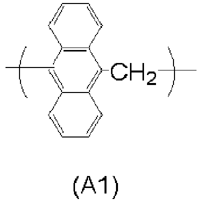

Under a nitrogen atmosphere, 60.0 g of the compound (b1) and 300 g of 1,2-dichloroethane were mixed together and then homogeneously dispersed at an internal temperature of 60°C. Subsequently, 55.4 g of methanesulfonic acid was added dropwise over 1 hour, and the mixture was heated and stirred at an internal temperature of 70°C for 6 hours. After cooling to room temperature, 400 g of 1,2-dichloroethane was added thereto, and then insoluble matter was removed by filtration. The collected filtrate was washed six times with 200 g of pure water, and the organic layer was evaporated under reduced pressure to dryness. After adding 150 g of THF to the residue to yield a homogeneous solution, a crystal was precipitated in 500 g of methanol. The precipitated crystal was separated by filtration, washed with 300 g of methanol and 300 g of diisopropyl ether in this order, and collected. The collected crystal was vacuum-dried at 70°C to obtain 33.2 g of a polymer (A1).

The weight-average molecular weight (Mw) and the dispersity (Mw/Mn) were determined by GPC, and the following results were obtained.
(A1): Mw=560, Mw/Mn=2.43

### [Synthesis Example 2] Synthesis of Polymer (A2)

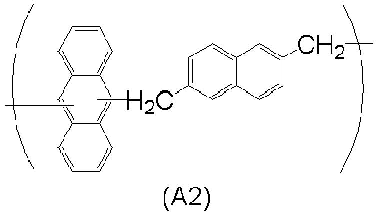

Under a nitrogen atmosphere, 30.0 g of the compound (b2), 22.2 g of the compound (b3), and 300 g of 1,2-dichloroethane were mixed together and then homogeneously dispersed at an internal temperature of 60°C. Subsequently, 55.0 g of methanesulfonic acid was added dropwise over 1 hour, and the mixture was heated and stirred at an internal temperature of 70°C for 24 hours. After cooling to room temperature, 400 g of 1,2-dichloroethane was added thereto, and then insoluble matter was removed by filtration. The collected filtrate was washed six times with 200 g of pure water, and the organic layer was evaporated under reduced pressure to dryness. After adding 150 g of THF to the residue to yield a homogeneous solution, a crystal was precipitated in 500 g of diisopropyl ether. The precipitated crystal was separated by filtration, washed twice with 300 g of diisopropyl ether, and collected. The collected crystal was vacuum-dried at 70°C to obtain 45.6 g of a polymer (A2).

The weight-average molecular weight (Mw) and the dispersity (Mw/Mn) were determined by GPC, and the following results were obtained.
(A2): Mw=3560, Mw/Mn=1.93

### [Synthesis Example 3] Synthesis of Polymer (A3)

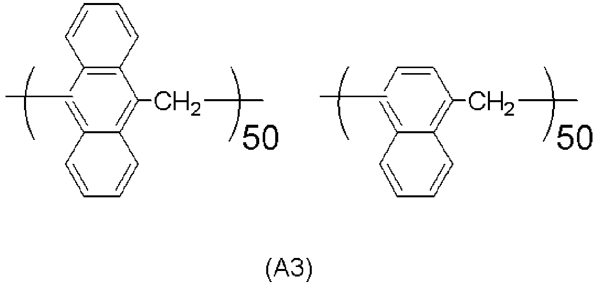

Under a nitrogen atmosphere, 30.0 g of the compound (b1), 22.8 g of the compound (b4), and 260 g of 1,2-dichloroethane were mixed together and then homogeneously dispersed at an internal temperature of 60°C. Subsequently, 55.4 g of methanesulfonic acid was added dropwise over 1 hour, and the mixture was heated and stirred at an internal temperature of 70°C for 6 hours. After cooling to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 120 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain 33.3 g of a polymer (A3).

The weight-average molecular weight (Mw) and the dispersity (Mw/Mn) were determined by GPC, and the following results were obtained.
(A3): Mw=720, Mw/Mn=2.13

### [Synthesis Example 4] Synthesis of Polymer (A4)

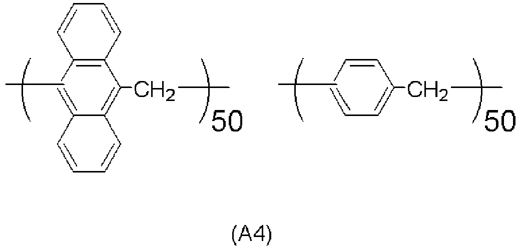

Under a nitrogen atmosphere, 30.0 g of the compound (b1), 15.6 g of the compound (b5), and 230 g of 1,2-dichloroethane were mixed together and then homogeneously dispersed at an internal temperature of 60°C. Subsequently, 55.4 g of methanesulfonic acid was added dropwise over 1 hour, and the mixture was heated and stirred at an internal temperature of 70°C for 6 hours. After cooling to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 120 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain 27.3 g of a polymer (A4).

The weight-average molecular weight (Mw) and the dispersity (Mw/Mn) were determined by GPC, and the following results were obtained.
(A4): Mw=680, Mw/Mn=2.27

### [Synthesis Example 5] Synthesis of Polymer (A5)

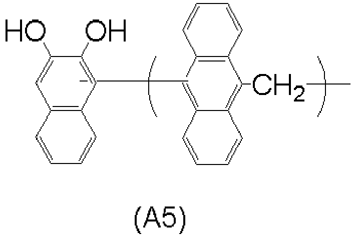

Under a nitrogen atmosphere, 60.0 g of the compound (b1), 4.6 g of the compound (b6), and 325 g of 1,2-dichloroethane were mixed together and then homogeneously dispersed at an internal temperature of 60°C. Subsequently, 55.4 g of methanesulfonic acid was added dropwise over 1 hour, and the mixture was heated and stirred at an internal temperature of 70°C for 6 hours. After cooling to room temperature, 200 g of 1,2-dichloroethane was added thereto, and then insoluble matter was removed by filtration. The collected filtrate was washed six times with 100 g of pure water, and the organic layer was evaporated under reduced pressure to dryness. After adding 200 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain 36.3 g of a polymer (A5).

The weight-average molecular weight (Mw) and the dispersity (Mw/Mn) were determined by GPC, and the following results were obtained.
(A5): Mw=700, Mw/Mn=1.43

### [Synthesis Example 6] Synthesis of Polymer (A6)

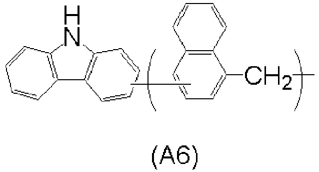

Under a nitrogen atmosphere, 60.0 g of the compound (b4), 6.3 g of the compound (b7), and 350 g of 1,2-dichloroethane were mixed together to form a homogeneous solution at an internal temperature of 60°C. Subsequently, 80.2 g of methanesulfonic acid was added dropwise over 1 hour, and the mixture was heated and stirred at an internal temperature of 70°C for 6 hours. After cooling to room temperature, 200 g of 1,2-dichloroethane was added thereto, the organic layer was washed six times with 100 g of pure water, and the organic layer was evaporated under reduced pressure to dryness. After adding 200 g of THF to the residue to yield a homogeneous solution, a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain 35.5 g of a polymer (A6).

The weight-average molecular weight (Mw) and the dispersity (Mw/Mn) were determined by GPC, and the following results were obtained.
(A6): Mw=730, Mw/Mn=1.38

### [Synthesis Example 7] Synthesis of Polymer (A7)

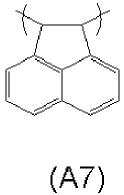

Under a nitrogen atmosphere, 3.8 g of methanesulfonic acid and 30 g of methylene chloride were mixed together and homogenized at an internal temperature of 30°C. Subsequently, a mixed solution of 30.0 g of acenaphthylene and 60.0 g of methylene chloride was added dropwise over 1 hour, and the mixture was heated and stirred at an internal temperature of 35°C for 24 hours. After cooling to room temperature, 300 g of toluene was added thereto. The product was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 28.7 g of a polymer (A7).

The weight-average molecular weight (Mw) and the dispersity (Mw/Mn) were determined by GPC, and the following results were obtained.
(A7): Mw=2400, Mw/Mn=1.93

### [Synthesis Example 8] Synthesis of Polymer (A8)

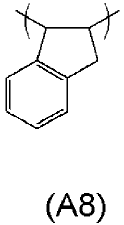

Under a nitrogen atmosphere, 5.0 g of methanesulfonic acid and 30.0 g of methylene chloride were mixed together and homogenized at an internal temperature of 30°C. Subsequently, a mixed solution of 30.0 g of indene and 60.0 g of methylene chloride was added dropwise over 1 hour, and the mixture was heated and stirred at an internal temperature of 35°C for 24 hours. After cooling to room temperature, 300 g of toluene was added thereto. The product was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 26.9 g of a polymer (A8).

The weight-average molecular weight (Mw) and the dispersity (Mw/Mn) were determined by GPC, and the following results were obtained.
(A8): Mw=2500, Mw/Mn=1.83

### [Synthesis Example 9] Synthesis of Polymer (A9)

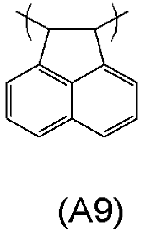

Under a nitrogen atmosphere, 37.5 g of propylene glycol monomethyl ether acetate (PGMEA) was stirred at 80°C. Then, a mixture of 50.0 g of acenaphthylene and 82.5 g of PGMEA and a mixture of 3.8 g of dimethyl 2,2-azobis(2-methylpropionate) and 30.0 g of PGMEA were added thereto simultaneously and separately over 2 hours. The obtained mixture was further heated and stirred for 24 hours, and then cooled to room temperature. The reaction solution was added dropwise to 750 g of methanol to precipitate a polymer. The precipitated crystal was separated by filtration, washed twice with 300 g of methanol, and collected. The collected crystal was vacuum-dried at 70°C to obtain 48.3 g of a polymer (A9) .

The weight-average molecular weight (Mw) and the dispersity (Mw/Mn) were determined by GPC, and the following results were obtained.
(A9): Mw=4100, Mw/Mn=1.73

### [Synthesis Example 10] Synthesis of Polymer (A10)

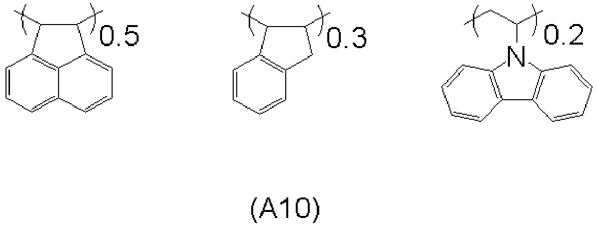

Under a nitrogen atmosphere, 5.7 g of methanesulfonic acid and 29.5 g of methylene chloride were mixed together and homogenized at an internal temperature of 30°C. Subsequently, a mixed solution of 15.0 g of acenaphthylene, 6.9 g of indene, 7.6 g of 9-vinylcarbazole, and 59.0 g of methylene chloride was added dropwise over 1 hour, and the mixture was heated and stirred at an internal temperature of 35°C for 24 hours. After cooling to room temperature, 300 g of toluene was added thereto. The product was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 27.9 g of a polymer (A10).

The weight-average molecular weight (Mw) and the dispersity (Mw/Mn) were determined by GPC, and the following results were obtained.
(A10): Mw=4000, Mw/Mn=2.15

### [Synthesis Example 11] Synthesis of Polymer (A11)

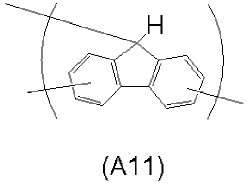

Under a nitrogen atmosphere, 200 g of 1,2-dichloroethane was added to 30.0 g of the compound (b8) to form a homogeneous solution at an internal temperature of 50°C. 15.8 g of methanesulfonic acid was slowly added thereto, and a reaction was allowed to take place at an inner temperature of 70°C for 8 hours. After cooling to room temperature, 500 g of toluene was added thereto. The product was washed six times with 100 g of pure water, and the organic layer was evaporated under reduced pressure to dryness. After adding 100 g of THF (tetrahydrofuran) to the residue to yield a homogeneous solution, a crystal was precipitated in 300 g of methanol. The precipitated crystal was separated by filtration, washed twice with 200 g of methanol, and collected. The collected crystal was vacuum-dried at 70°C to obtain 25.6 g of a polymer (A11), shown by the above formula.

The weight-average molecular weight (Mw) and the dispersity (Mw/Mn) were determined by GPC measurement, and the following results were obtained.
(A11): Mw=2600, Mw/Mn=1.68

### [Synthesis Example 12] Synthesis of Polymer (A12)

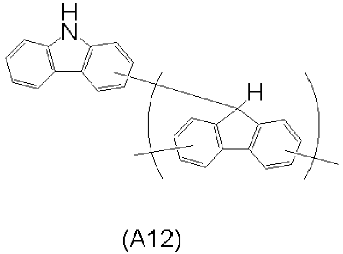

Under a nitrogen atmosphere, 2.75 g of the compound (b7), 30.0 g of the compound (b8), and 200 g of 1,2-dichloroethane were added together to form a homogeneous solution at an internal temperature of 50°C. 15.8 g of methanesulfonic acid was slowly added thereto, and a reaction was allowed to take place at an internal temperature of 70°C for 8 hours. After cooling to room temperature, 500 g of toluene was added thereto. The product was washed six times with 100 g of pure water, and the organic layer was evaporated under reduced pressure to dryness. After adding 100 g of THF to the residue to yield a homogeneous solution, a crystal was precipitated in 300 g of methanol. The precipitated crystal was separated by filtration, washed twice with 200 g of methanol, and collected. The collected crystal was vacuum-dried at 70°C to obtain 25.4 g of a polymer (A12), shown by the above formula.

The weight-average molecular weight (Mw) and the dispersity (Mw/Mn) were determined by GPC measurement, and the following results were obtained.
(A12): Mw=1420, Mw/Mn=1.53

### [Synthesis Example 13] Synthesis of Polymer (A13)

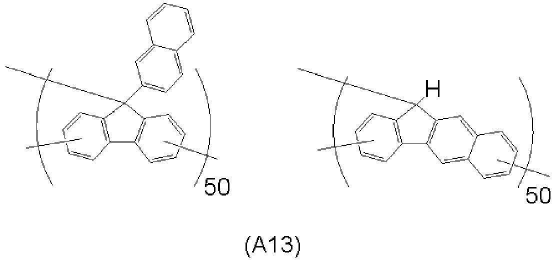

Under a nitrogen atmosphere, 100 g of 1,2-dichloroethane was added to 10.0 g of the compound (b9) to form a homogeneous solution at an internal temperature of 50°C. 15.8 g of methanesulfonic acid was slowly added thereto, and a reaction was allowed to take place at an internal temperature of 70°C for 4 hours. After that, the internal temperature was cooled to 50°C, then a mixed solution of 13.7 g of the compound (b10) and 100 g of 1,2-dichloroethane, which had been homogenized beforehand, was slowly added dropwise thereto, the internal temperature was raised to 70°C again, and a reaction was allowed to take place for 8 hours. After cooling to room temperature, 500 g of toluene was added thereto. The product was washed six times with 100 g of pure water, and the organic layer was evaporated under reduced pressure to dryness. After adding 100 g of THF to the residue to yield a homogeneous solution, a crystal was precipitated in 300 g of methanol. The precipitated crystal was separated by filtration, washed twice with 200 g of methanol, and collected. The collected crystal was vacuum-dried at 70°C to obtain 18.7 g of a polymer (A13), shown by the above formula.

The weight-average molecular weight (Mw) and the dispersity (Mw/Mn) were determined by GPC measurement, and the following results were obtained.
(A13): Mw=2930, Mw/Mn=1.61

### [Synthesis of Comparative Compounds]

To synthesize comparative compounds (R2), (R3), and (R4), the compound group c ((c1) to (c6)) shown below was used.

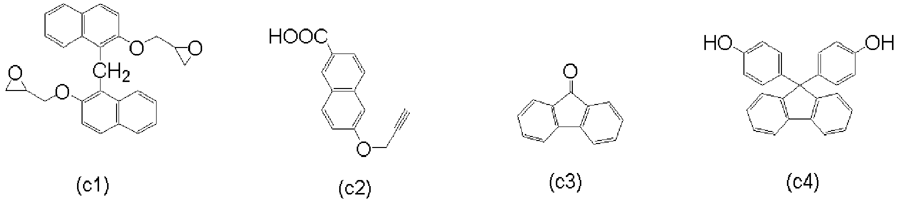

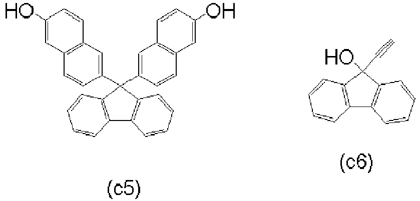

### [Comparative Synthesis Example 1] Synthesis of Comparative Compound (R1)

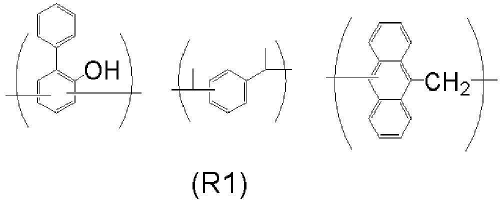

Under a nitrogen atmosphere, 15.6 g of 2-phenylphenol, 19.1 g of 9-anthracene methanol, 12.3 g of divinylbenzene, 30 g of cyclopentyl methyl ether (CPME), and 110 g of diethylene glycol dimethyl ether were added together and stirred at room temperature to form a homogeneous dispersion. After that, 1.14 g of trifluorosulfonic acid was slowly added thereto, and the mixture was further stirred for 5 minutes to form a homogeneous solution. Then, a reaction was allowed to take place for 4 hours in an oil bath at 140°C while removing generated water from the reaction system. The product was cooled to room temperature, diluted with 250 g of CPME, transferred to a separating funnel, and washed four times with ultrapure water. Then, the organic layer was evaporated under reduced pressure to dryness. 120 g of CPME was added to the residue, and a polymer was precipitated in 500 g of hexane. The precipitated crystal was separated by filtration, washed twice with 200 g of hexane, and collected. The collected crystal was vacuum-dried at 70°C to obtain a comparative compound (R1).

The weight-average molecular weight (Mw) and the dispersity (Mw/Mn) were determined by GPC, and the following results were obtained.
(R1): Mw=1960, Mw/Mn=1.57

### [Comparative Synthesis Example 2] Synthesis of Comparative Compound (R2)

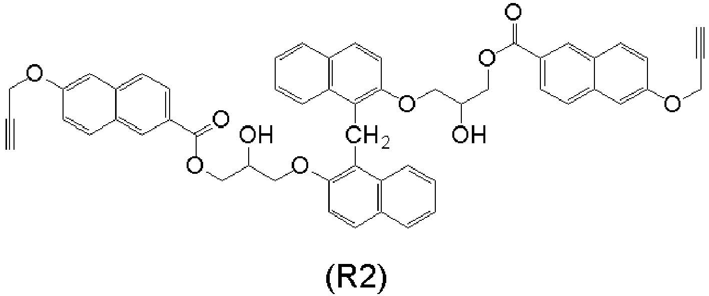

Under a nitrogen atmosphere, 80.0 g of the epoxy compound (c1), 51.0 g of the modifying agent (c2), and 600 g of 2-methoxy-1-propanol were added together to form a homogeneous solution at 100°C. Subsequently, 5.7 g of benzyltriethylammonium chloride was added thereto, and the mixture was stirred at 120°C for 12 hours. The product was cooled to room temperature, 1,500 g of methyl isobutyl ketone was added thereto, and the organic layer was washed five times with 300 g of pure water. The organic layer was evaporated under reduced pressure to dryness to obtain a comparative compound (R2) .

The weight-average molecular weight (Mw) and the dispersity (Mw/Mn) were determined by GPC, and the following results were obtained.
(R2): Mw=900, Mw/Mn=1.04

### [Comparative Synthesis Example 3] Synthesis of Comparative Compound (R3)

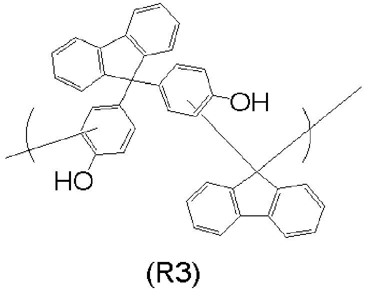

Under a nitrogen atmosphere, 20 g of 9-fluorenone (c3), 230 g of 9,9-bis(4-hydroxyphenyl)fluorene (c4), and dichloromethane (1,040 g) were added together to form a homogeneous solution at 40°C. Subsequently, trifluoromethanesulfonic acid (9 g) dissolved in dichloromethane (20 g) and 3-mercaptopropionic acid (0.6 g) were added thereto, and the mixture was stirred at 40°C for 4 hours. The product was cooled to room temperature, and the organic layer was washed five times with 300 g of pure water. The organic layer was evaporated under reduced pressure to dryness to obtain a comparative compound (R3).

The weight-average molecular weight (Mw) and the dispersity (Mw/Mn) were determined by GPC, and the following results were obtained.
(R3): Mw=680, Mw/Mn=1.26

### [Comparative Synthesis Example 4] Synthesis of Comparative Compound (R4)

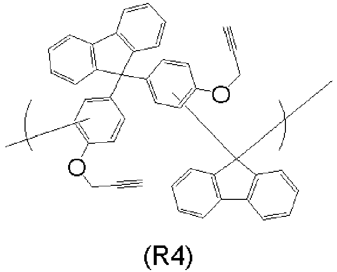

Under a nitrogen atmosphere, the comparative compound R3 (20 g) obtained in Comparative Synthesis Example 3, potassium carbonate (32 g), and acetone (62 g) were added together to form a homogeneous solution at 56°C. Subsequently, 3-bromo-1-propyne (28 g) was added slowly into the reaction vessel, and the mixture was stirred at 56°C for 3 hours. The product was cooled to room temperature, excessive potassium carbonate and salt were removed by filtration, and the precipitate was washed with acetone. The organic layer was washed five times with 300 g of pure water. The organic layer was evaporated under reduced pressure to dryness to obtain a comparative compound (R4).

The weight-average molecular weight (Mw) and the dispersity (Mw/Mn) were determined by GPC, and the following results were obtained.
(R4): Mw=1,040, Mw/Mn=1.38

### [Comparative Synthesis Example 5] Synthesis of Comparative Compound (R5)

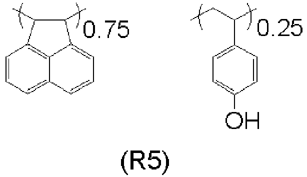

In a 200-mL flask, 15.2 g of acenaphthylene, 3.3 g of 4-hydroxystyrene, and as a solvent, 60 g of 1,2-dichloroethane were placed. As a polymerization initiator, 1 g of boron trifluoride was added, and after raising the temperature to 60°C, a reaction was allowed to take place for 25 hours. To the reaction solution, 1 L of methanol and 500 g of water was added to precipitate a polymer. The obtained white solid was collected by filtration and then dried to obtain 12 g of a polymer (comparative compound (R5)).

The weight-average molecular weight (Mw) and the dispersity (Mw/Mn) were determined by GPC, and the following results were obtained.
(R5): Mw=8800, Mw/Mn=1.82

### [Comparative Synthesis Example 6] Synthesis of Comparative Compound (R6)

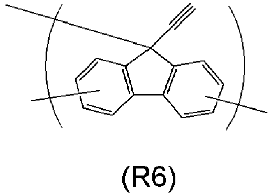

41.2 g of the tertiary alcohol (c6) and 160 g of methylene chloride were mixed. 19.2 g of methanesulfonic acid was slowly added dropwise thereto, and the mixture was heated under reflux for 8 hours. After cooling to room temperature, 250 g of toluene was added thereto, and washing with water and concentration under reduced pressure were performed to obtain 37.6 g of a comparative compound (R6).

The weight-average molecular weight (Mw) and the dispersity (Mw/Mn) were determined by GPC, and the following results were obtained.
(R6): Mw=1850, Mw/Mn=1.26

### [Synthesis Example: Synthesis of Crosslinking Agent (C)]

### [Synthesis Example 15] Synthesis of Compound (C1)

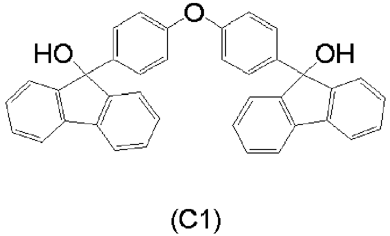

Under a nitrogen atmosphere, 500 mL of a 2.67 M solution of n-butyllithium in hexane was added to a mixed solution of 219 g of bis(4-bromophenyl) ether and 1,000 mL of t-butylmethyl ether, which had been cooled to -20°C, and the mixture was stirred at -20°C for 20 minutes. 229 g of 9-fluorenone was added, the temperature was gradually raised to room temperature, and the obtained mixture was stirred at room temperature for 4 hours. Water was added to terminate the reaction. The product was washed with water and concentrated under reduced pressure. Subsequently, hexane was added, and the generated solid was collected by filtration, washed with hexane, and dried under reduced pressure to obtain 293 g of a compound (C1).
(C1): Mw=540, Mw/Mn=1.02

### [Synthesis Example 16] Synthesis of Compound (C2)

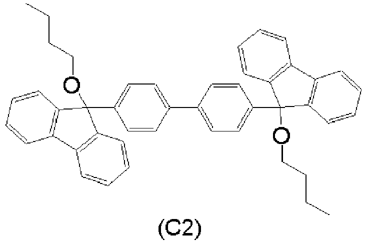

Under a nitrogen atmosphere, a suspension of 30.0 g of the compound (C1) and 172.8 g of 1-butanol was formed at an internal temperature of 80°C. 16.8 g of methanesulfonic acid was added slowly, and a reaction was allowed to take place at an internal temperature of 100°C for 6 hours. The product was cooled in an ice bath to precipitate a crystal. The precipitated crystal was then separated by filtration, washed twice with 200 g of butanol, washed three times with 200 g of diisopropyl ether, and collected. The collected crystal was vacuum-dried at 60°C to obtain 34.2 g of a compound (C2). The weight-average molecular weight (Mw) and the dispersity (Mw/Mn) were determined by GPC, and the following results were obtained.
(C2): Mw=640, Mw/Mn=1.01

### [Preparation of Composition (UDL-1) for Forming Resist Underlayer Film]

The polymer (A1), as a compound for forming a resist underlayer film, was dissolved at a ratio shown in Table 2 in a mixed solvent of propylene glycol monomethyl ether acetate (PGMEA) and cyclohexanone (CyHO) containing 0.5 mass% of a surfactant FC-4430 (manufactured by Sumitomo 3M Limited). The obtained solution was filtered through a 0.02-µm membrane filter to prepare a composition (UDL-1) for forming a resist underlayer film.

### [Preparation of Compositions (UDL-2 to -16) for Forming Resist Underlayer Film and Comparative Compositions (Comparative UDL-1 to -6) for Forming Resist Underlayer Film]

Each of compositions (UDL-2 to -16) for forming a resist underlayer film and comparative compositions (comparative UDL-1 to -6) for forming a resist underlayer film was prepared in the same manner as the composition (UDL-1) for forming a resist underlayer film, except that the kind and the contained amount of each component were as shown in Table 2. In Table 2, "-" indicates that the component was not used. The following formula (E1) was used for the acid generator (TAG), and the following formula (G1) was used for the flowability accelerator.

### [Acid Generator]

The thermal acid generator (E1) used in compositions for forming a resist underlayer film is shown below.

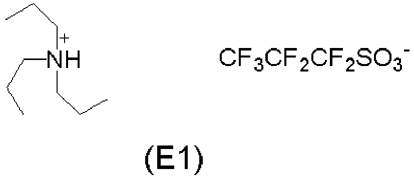

### [Flowability Accelerator]

The flowability accelerator (G1) used in a composition for forming a resist underlayer film is shown in Table 1.

**[Table 1]**

| Compound | Mw (calculated value) | Weight reduction rate on heating from 30°C to 190°C | Weight reduction rate on heating from 30°C to 350°C |
|---|---|---|---|
| 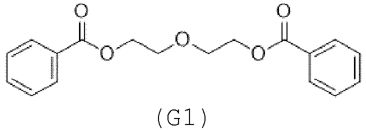 | 314 | 1 | 100 |

**[Table 2]**

| Composition for forming resist underlayer film | Polymer (A) | Crosslinking agent (C) | Additive | Organic solvent (B) (containing surfactant (D)) |
|---|---|---|---|---|
| | (parts by mass) | (parts by mass) | (parts by mass) | (parts by mass) |
| UDL-1 | A1 (15) | - | - | PGMEA/CyHO (45/40) |
| UDL-2 | A2 (15) | - | - | PGMEA/CyHO (45/40) |
| UDL-3 | A3 (15) | - | - | PGMEA/CyHO (45/40) |
| UDL-4 | A4 (15) | - | - | PGMEA/CyHO (45/40) |
| UDL-5 | A5 (15) | - | - | PGMEA/CyHO (45/40) |
| UDL-6 | A6 (15) | - | - | PGMEA/CyHO (45/40) |
| UDL-7 | A1 (12) | C1 (3) | E1 (0.2) | PGMEA/CyHO (45/40) |
| UDL-8 | A1 (15) | - | G1 (3) | PGMEA/CyHO (45/40) |
| UDL-9 | A7 (15) | - | - | PGMEA/CyHO (45/40) |
| UDL-10 | A8 (12) | - | - | PGMEA/CyHO (45/40) |
| UDL-11 | A9 (12) | - | - | PGMEA/CyHO (45/40) |
| UDL-12 | A10 (12) | C1 (3) | E1 (0.2) | PGMEA/CyHO (45/40) |
| UDL-13 | A7 (8) | C2 (3) | E1 (0.2) | PGMEA/CyHO (45/40) |
| | A8 (4) | | | |
| UDL-14 | A11 (15) | - | - | PGMEA (85) |
| UDL-15 | A12 (12) | C1 (3) | E1 (0.2) | PGMEA (85) |
| UDL-16 | A13 (12) | C2 (3) | E1 (0.2) | PGMEA (85) |
| Comparative UDL-1 | R1 (15) | - | E1 (0.2) | PGMEA (85) |
| Comparative UDL-2 | R2 (15) | - | - | PGMEA (85) |
| Comparative UDL-3 | R3 (15) | - | - | PGMEA (85) |
| Comparative UDL-4 | R4 (15) | - | - | PGMEA (85) |
| Comparative UDL-5 | R5 (12) | C1 (3) | E1 (0.2) | PGMEA/CyHO (50/35) |
| Comparative UDL-6 | R6 (15) | - | - | PGMEA (85) |

### [Example 1 and Comparative Example 1: Dry Etching Resistance Evaluation]

Each of the compositions (UDL-1 to -16 and comparative UDL-1 to -6) for forming a resist underlayer film prepared as described above was respectively applied onto a silicon substrate and baked at 250°C for 60 seconds. After that, the film thickness from the central portion to the peripheral portion of the substrate was measured and the average film thickness (a [nm]) was calculated. Subsequently, etching was performed with CF₄ gas under the conditions given below by using an etching apparatus Telius manufactured by Tokyo Electron Ltd., and the film thickness "b" was measured. Then, the film thickness etched in 1 minute was calculated as an etching rate A (nm/min) from the film thickness etched (film thickness "a" - film thickness "b") by the CF₄ gas in a specified time. Table 3 shows the results.

In addition, separately from the above, each of the compositions (UDL-1 to -16 and comparative UDL-1 to -6) for forming a resist underlayer film was respectively applied onto a silicon substrate and heated at 250°C for 60 seconds. After that, plasma treatment was respectively performed under the plasma treatment conditions given below to form a resist underlayer film. Then, the film thickness "c" was measured. Subsequently, etching was performed with CF₄ gas under the conditions given below by using an etching apparatus Telius manufactured by Tokyo Electron Ltd., and the film thickness "d" was measured. Then, the film thickness etched in 1 minute was calculated as an etching rate B

(nm/min) from the film thickness etched (film thickness "c" - film thickness "d") by the CF₄ gas in a specified time.

A smaller value of the etching rate indicates that the composition has better resistance to etching with the CF₄ gas.

The etching resistance of the cured films (resist underlayer films) subjected to additional plasma treatment and that of the underlayer-film-precursor films obtained by baking at 250°C were compared, and the effect of the additional plasma treatment on the improvement of etching resistance (etching rate A (nm/min) - etching rate B (nm/min)) was calculated.

The etching conditions were as shown below. Conditions of dry etching with CF₄ gas
Chamber pressure: 100 mT
RF-power (upper portion): 500 W
RF-power (lower portion): 400 W
CF₄ gas flow rate: 300 sccm
Time: 30 sec

### Additional Treatment Conditions (Plasma Treatment)

Each of the substrates heated at 250°C for 60 seconds was subjected to plasma treatment under the following conditions by using an etching apparatus Telius manufactured by Tokyo Electron Ltd.
Plasma treatment conditions
Chamber pressure: 100 mT
RF-power (upper portion): 100 W
RF-power (lower portion): 3500 W
H₂ gas flow rate: 200 sccm
Time: 20 sec

**[Table 3]**

| Example 1 and Comparative Example 1 | Composition for forming resist underlayer film | CF₄ etching rate A after heat treatment at 250°C | CF₄ etching rate B after additional treatment by plasma irradiation | Improvement from additional treatment by plasma irradiation |
|---|---|---|---|---|
| | | (nm/min) | (nm/min) | (nm/min) |
| Example 1-1 | UDL-1 | 72 | 42 | 30 |
| Example 1-2 | UDL-2 | 76 | 46 | 30 |
| Example 1-3 | UDL-3 | 74 | 48 | 26 |
| Example 1-4 | UDL-4 | 73 | 44 | 29 |
| Example 1-5 | UDL-5 | 78 | 47 | 31 |
| Example 1-6 | UDL-6 | 76 | 46 | 30 |
| Example 1-7 | UDL-7 | 73 | 42 | 31 |
| Example 1-8 | UDL-8 | 72 | 42 | 30 |
| Example 1-9 | UDL-9 | 66 | 45 | 21 |
| Example 1-10 | UDL-10 | 71 | 48 | 23 |
| Example 1-11 | UDL-11 | 68 | 46 | 22 |
| Example 1-12 | UDL-12 | 69 | 47 | 22 |
| Example 1-13 | UDL-13 | 68 | 46 | 22 |
| Example 1-14 | UDL-14 | 70 | 51 | 19 |
| Example 1-15 | UDL-15 | 72 | 53 | 19 |
| Example 1-16 | UDL-16 | 73 | 54 | 19 |
| Comparative Example 1-1 | Comparative UDL-1 | 74 | 66 | 8 |
| Comparative Example 1-2 | Comparative UDL-2 | 83 | 75 | 8 |
| Comparative Example 1-3 | Comparative UDL-3 | 76 | 69 | 7 |
| Comparative Example 1-4 | Comparative UDL-4 | 78 | 70 | 8 |
| Comparative Example 1-5 | Comparative UDL-5 | 73 | 63 | 10 |
| Comparative Example 1-6 | Comparative UDL-6 | 73 | 63 | 10 |

As shown in Table 3, in Examples 1-1 to 1-16, where the compositions (UDL-1 to -16) for forming a resist underlayer film were used, dry etching resistance to CF₄ gas was greatly improved by the additional treatment using plasma irradiation. It is thought that, since the compositions for forming a resist underlayer film used in Examples 1-1 to 1-16, which are examples of the present invention, contained no hydroxy groups or organic groups represented by the general formulae (1) in the repeating units of the polymers, carbon bonds of the resist underlayer-film-precursor films were dissociated and recombined by the plasma irradiation, so that a resist underlayer film, being a cured film having a diamond-like carbon structure, was easily reconstructed, and excellent dry etching resistance was exhibited. On the other hand, regarding comparative UDL-1 to -6, the improvement in dry etching resistance achieved by the additional treatment was small, and was 10 nm/min or less. It is conjectured that, in comparative UDL-1 to -6, hydroxy groups or organic groups represented by the general formulae (1) were contained in the repeating units of the polymers, so that not only dissociation and recombination of the carbon bonds but also a crosslinking reaction took place competitively, and film modification by the plasma irradiation did not progress sufficiently.

UDL-5 contained hydroxy groups in the terminal structure of the polymer, but no hydroxy groups were contained in the repeating unit of the polymer. Therefore, it is conjectured that the dissociation and recombination of carbon bonds progressed during the plasma irradiation without being inhibited by a crosslinking reaction, and the film was modified to a film that exhibited excellent dry etching resistance.

### [Example 2 and Comparative Example 2: Filling Property Evaluation]

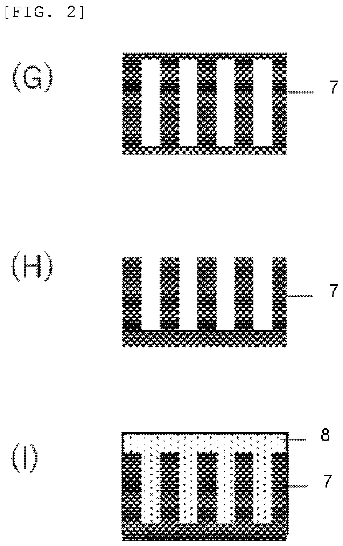

Each of the compositions (UDL-1 to -16 and comparative UDL-1 to -6) for forming a resist underlayer film was respectively applied onto an SiO₂ wafer substrate having a dense line-and-space pattern (line width = 60 nm, line depth = 100 nm, distance between the centers of two adjacent lines = 120 nm). Subsequently, the coating film was baked at 250°C for 60 seconds to form a resist underlayer-film-precursor film having a film thickness of 100 nm. The substrate used was a base substrate 7 (SiO₂ wafer substrate) having a dense line-and-space pattern shown in FIG. 2(G) (downward view) and (H) (cross-sectional view). Subsequently, plasma irradiation treatment was respectively performed under the same additional treatment conditions as in the above dry etching resistance evaluation. The cross-sectional shape of each of the obtained wafer substrates was observed using an electron microscope (S-4700: manufactured by Hitachi, Ltd.), and the presence/absence of voids (gaps) inside the resist underlayer film filling the space between the lines was confirmed. Table 4 shows the results. In this evaluation, when a composition for forming a resist underlayer film having a poor filling property is used, voids are generated inside the resist underlayer film filling the space between the lines. In this evaluation, when a composition for forming a resist underlayer film having a desirable filling property is used, as shown in FIG. 2(I), the inside of the resist underlayer film filling the space between the lines of the base substrate 7 having the dense line-and-space pattern is filled with a void-free resist underlayer film 8.

**[Table 4]**

| Example 2 and Comparative Example 2 | Composition for forming resist underlayer film | Filling property |
|---|---|---|
| | | Presence/absence of voids |
| Example 2-1 | UDL-1 | Absent |
| Example 2-2 | UDL-2 | Absent |
| Example 2-3 | UDL-3 | Absent |
| Example 2-4 | UDL-4 | Absent |
| Example 2-5 | UDL-5 | Absent |
| Example 2-6 | UDL-6 | Absent |
| Example 2-7 | UDL-7 | Absent |
| Example 2-8 | UDL-8 | Absent |
| Example 2-9 | UDL-9 | Absent |
| Example 2-10 | UDL-10 | Absent |
| Example 2-11 | UDL-11 | Absent |
| Example 2-12 | UDL-12 | Absent |
| Example 2-13 | UDL-13 | Absent |
| Example 2-14 | UDL-14 | Absent |
| Example 2-15 | UDL-15 | Absent |
| Example 2-16 | UDL-16 | Absent |
| Comparative Example 2-1 | Comparative UDL-1 | Absent |
| Comparative Example 2-2 | Comparative UDL-2 | Absent |
| Comparative Example 2-3 | Comparative UDL-3 | Absent |
| Comparative Example 2-4 | Comparative UDL-4 | Absent |
| Comparative Example 2-5 | Comparative UDL-5 | Absent |
| Comparative Example 2-6 | Comparative UDL-6 | Absent |

As shown in Table 4, it was successfully confirmed that the compositions (UDL-1 to -16) for forming a resist underlayer film used in Example 2 of the present invention was able to fill the dense line-and-space pattern without the generation of voids, and had excellent filling property even after the additional treatment by plasma irradiation. It was also confirmed that there was no problem with the filling property in comparative UDL-1 to -6 either.

### [Example 3 and Comparative Example 3: Patterning Process]

Each of the compositions (UDL-1 to -16 and comparative UDL-1 to -6) for forming a resist underlayer film was respectively applied onto a silicon wafer substrate on which an SiO₂ film having a trench pattern (trench width: 10 um, trench depth: 0.10 µm) was formed, and baked at 250°C for 60 seconds in the atmosphere to form a resist underlayer-film-precursor film having a thickness of 100 nm. After that, a plasma irradiation treatment similar to that in the above-described dry etching resistance evaluation was performed. A silicon-containing resist middle layer film material (SOG-1) was applied thereto, followed by baking at 220°C for 60 seconds to form a resist middle layer film having a thickness of 20 nm. A monolayer resist material for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film material (SOG-1) was prepared by the following procedure: a polymer represented by an ArF silicon-containing middle layer film polymer (SiP1) and a crosslinking catalyst (CAT1) were dissolved in propylene glycol monoethyl ether, as an organic solvent, containing 0.1 mass% of FC-4430 (manufactured by Sumitomo 3M Limited) in the proportion shown in Table 5; and the obtained solution was filtered through a filter made of a fluororesin and having a pore size of 0.1 um to prepare a silicon-containing resist middle layer film material (SOG-1).

**[Table 5]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the used ArF silicon-containing middle layer film polymer (SiP1) and crosslinking catalyst (CAT1) are shown below.

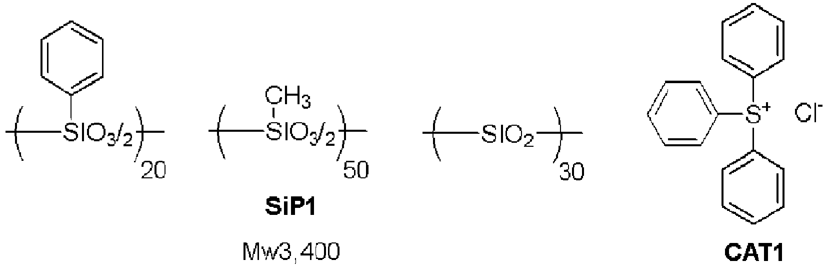

The resist upper layer film material (monolayer resist material for ArF) was prepared by the following procedure: a polymer (RP1), an acid generator (PAG1), and a basic compound (Amine1) were dissolved in propylene glycol monoethyl ether acetate (PGMEA), as a solvent, containing 0.1 mass% of a surfactant FC-4430 (manufactured by Sumitomo 3M Limited), each in the proportion shown in Table 6; and then the obtained solution was filtered through a 0.1-µm filter made of a fluororesin to prepare a monolayer resist material for ArF.

**[Table 6]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (monolayer resist material for ArF) are shown below.

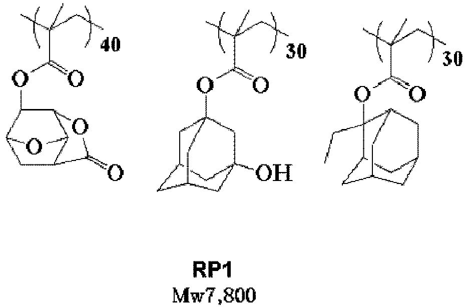

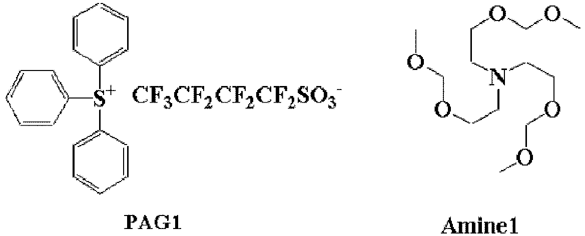

The liquid immersion top coat composition (TC-1) was prepared by dissolving a top coat polymer (PP1) in an organic solvent at the proportion shown in Table 7, and filtering the solution through a 0.1-µm filter made of a fluororesin.

**[Table 7]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) used for the liquid immersion top coat composition (TC-1) is shown below.

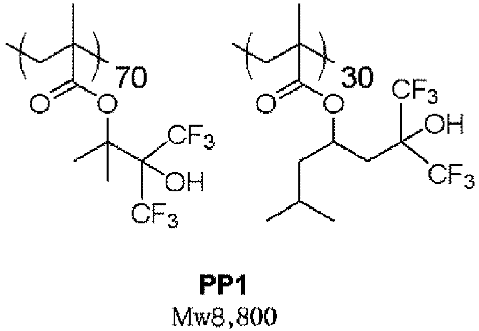

Then, the resist upper layer film was subjected to pattern exposure with an ArF liquid immersion exposure apparatus (NSR-S610C manufactured by Nikon Corporation, NA: 1.30, σ: 0.98/0.78, 35° s-polarized dipole illumination, 6% halftone phase shift mask), then baked at 100°C for 60 seconds (PEB), and developed with a 2.38% by mass aqueous solution of tetramethylammonium hydroxide (TMAH) for 30 seconds. In this manner, a 45-nm 1:1 positive line-and-space pattern (a resist pattern) was obtained.

Subsequently, the silicon-containing resist middle layer film material (SOG-1) was etched by dry etching using an etching apparatus Telius manufactured by Tokyo Electron Ltd. while using the resist pattern as a mask to form a hard mask pattern (SOG-1 pattern).

Next, the resist underlayer film was etched while using the obtained SOG-1 pattern as a mask to form a resist underlayer film pattern.

Then, the SiO₂ film was etched while using the obtained resist underlayer film pattern as a mask. The etching conditions were as follows.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 55 sec

### Conditions in transferring resist underlayer film pattern to SiO₂ film

Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 130 sec

Table 8 shows the results obtained by observing the cross section of the pattern formed in the SiO₂ film with an electron microscope (S-4700) manufactured by Hitachi, Ltd.

**[Table 8]**

| Example 3 and Comparative Example 3 | Composition for forming resist underlayer film | Pattern profile after etching for transferring pattern to substrate | CD after substrate processing | LWR after substrate processing |
|---|---|---|---|---|
| | | | nm | nm |
| Example 3-1 | UDL-1 | Vertical profile | 45 | 1.9 |
| Example 3-2 | UDL-2 | Vertical profile | 45 | 2.0 |
| Example 3-3 | UDL-3 | Vertical profile | 44 | 2.0 |
| Example 3-4 | UDL-4 | Vertical profile | 45 | 1.9 |
| Example 3-5 | UDL-5 | Vertical profile | 45 | 2.0 |
| Example 3-6 | UDL-6 | Vertical profile | 44 | 2.0 |
| Example 3-7 | UDL-7 | Vertical profile | 45 | 1.9 |
| Example 3-8 | UDL-8 | Vertical profile | 45 | 1.9 |
| Example 3-9 | UDL-9 | Vertical profile | 45 | 1.9 |
| Example 3-10 | UDL-10 | Vertical profile | 44 | 2.0 |
| Example 3-11 | UDL-11 | Vertical profile | 45 | 2.0 |
| Example 3-12 | UDL-12 | Vertical profile | 45 | 2.0 |
| Example 3-13 | UDL-13 | Vertical profile | 45 | 2.0 |
| Example 3-14 | UDL-14 | Vertical profile | 44 | 2.0 |
| Example 3-15 | UDL-15 | Vertical profile | 44 | 2.0 |
| Example 3-16 | UDL-16 | Vertical profile | 44 | 2.0 |
| Comparative Example 3-1 | Comparative UDL-1 | Vertical profile | 44 | 2.3 |
| Comparative Example 3-2 | Comparative UDL-2 | Vertical profile | 44 | 2.5 |
| Comparative Example 3-3 | Comparative UDL-3 | Vertical profile | 43 | 2.4 |
| Comparative Example 3-4 | Comparative UDL-4 | Vertical profile | 43 | 2.4 |
| Comparative Example 3-5 | Comparative UDL-5 | Vertical profile | 44 | 2.3 |
| Comparative Example 3-6 | Comparative UDL-6 | Vertical profile | 44 | 2.3 |

As shown in Table 8, in Examples 3-1 to 3-16, where the resist underlayer film was formed according to the inventive method for forming a resist underlayer film by using one of the compositions (UDL-1 to -16) for forming a resist underlayer film, the resist upper layer film pattern was desirably transferred to the substrate in the end in every case. It was thus confirmed that the inventive method for forming a resist underlayer film is suitably used for fine processing using the multilayer resist method. On the other hand, in Comparative Examples 3-1 to 3-6, using comparative UDL-1 to -6, which were found to have insufficient etching resistance in the above-described etching resistance evaluation compared to when the inventive method for forming a resist underlayer film was used, the pattern profile after the etching to transfer the pattern to the substrate was a vertical profile, but degradation in LWR was observed after the substrate processing.

As seen from the above, the inventive method for forming a resist underlayer film makes it possible to form, by irradiation with plasma, a resist underlayer film that exhibits excellent dry etching resistance at the time of substrate processing, and therefore, is significantly useful in next-generation fine processing processes. It was also revealed that the inventive patterning process, using this method, makes it possible to form fine patterns with a high degree of accuracy even when a body to be processed is a substrate having a step.

The present description includes the following embodiments.
[1] A method for forming a resist underlayer film on a substrate, the method comprising the steps of:
   (i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and
   (ii) forming a resist underlayer film by curing the underlayer-film-precursor film by plasma irradiation,
      wherein the polymer (A) is an aromatic ring-containing resin containing no hydroxy groups or organic groups represented by the following general formulae (1) in a repeating unit contained in the polymer, 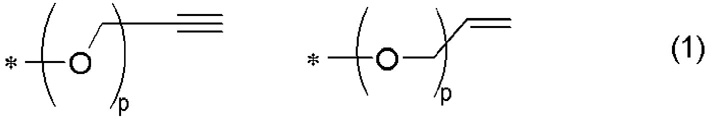 wherein "p" represents 0 or 1, and "*" represents an attachment point.
[2] The method for forming a resist underlayer film according to [1], wherein the aromatic ring-containing resin of the polymer (A) contains a structure selected from the group consisting of structures shown by the following formulae (1-1). 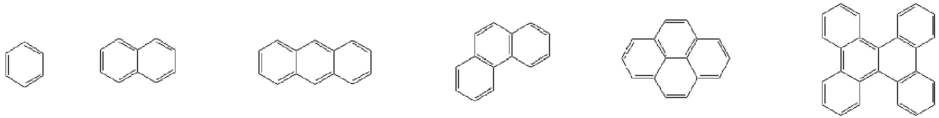 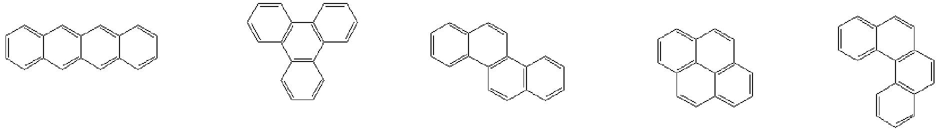 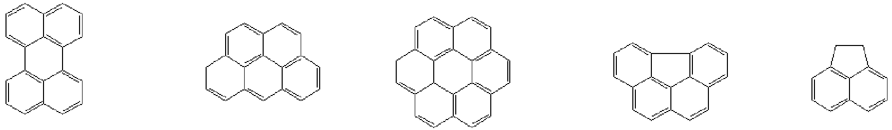 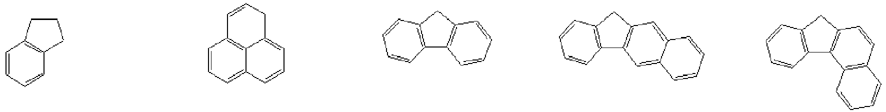 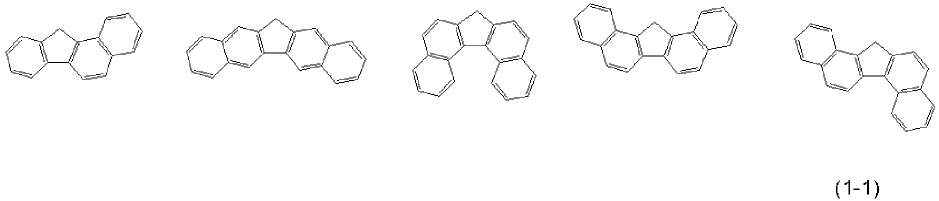
[3] The method for forming a resist underlayer film according to [1] or [2], wherein the polymer (A) has any of constitutional units represented by the following general formulae (A-1), (A-2), (A-3), (A-4), and (A-5), 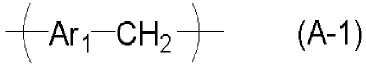 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1), 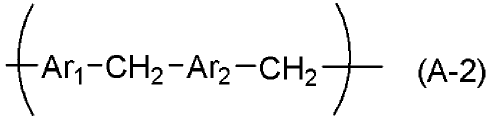 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1); and Ar₂ is a different fused aromatic ring from Ar₁, and represents an unsubstituted fused aromatic ring or a fused aromatic ring containing, as a substituent, a divalent organic group having 1 to 20 carbon atoms and containing no hydroxy groups or organic groups represented by the general formulae (1), 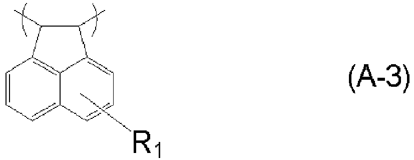 wherein R₁ represents a hydrogen atom, a halogen atom, or a linear, branched, or cyclic hydrocarbon group having 1 to 20 carbon atoms, 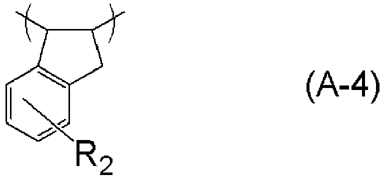 wherein R₂ represents a hydrogen atom, a halogen atom, or a linear, branched, or cyclic hydrocarbon group having 1 to 20 carbon atoms, 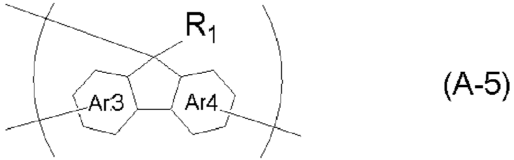 wherein R₁ represents a hydrogen atom or a monovalent organic group having 1 to 50 carbon atoms and containing no hydroxy groups or organic groups represented by the general formulae (1); and Ar3 and Ar4 each represent an unsubstituted benzene ring or naphthalene ring.
[4] The method for forming a resist underlayer film according to any one of [1] to [3], wherein the polymer (A) has a molecular weight of 300 to 5,000 as measured by gel permeation chromatography in terms of polystyrene.
[5] The method for forming a resist underlayer film according to any one of [1] to [4], wherein the composition for forming a resist underlayer film further contains one or more of:
   (C) a crosslinking agent;
   (D) a surfactant;
   (E) an acid generator; and
   (F) a plasticizer.
[6] The method for forming a resist underlayer film according to [5], wherein the crosslinking agent (C) has a structure represented by the following general formula (C-1), 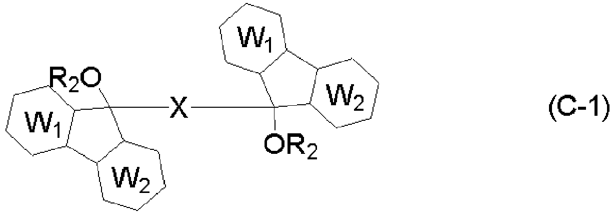 wherein W₁ and W₂ each represent a benzene ring or naphthalene ring optionally having a substituent; R₂ represents a hydrogen atom or a monovalent organic group having 1 to 20 carbon atoms; and X represents any group represented by the following general formulae (2). 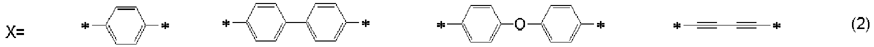
[7] The method for forming a resist underlayer film according to any one of [1] to [6], wherein the plasma irradiation in the step (ii) is performed under an atmosphere of N₂, NF₃, H₂, fluorocarbon, a rare gas, or a mixture of any thereof.
[8] The method for forming a resist underlayer film according to any one of [1] to [7], wherein the heat treatment in the step (i) is performed under an atmosphere with an oxygen concentration of 1% or more and 21% or less.
[9] The method for forming a resist underlayer film according to any one of [1] to [7], wherein the heat treatment in the step (i) is performed under an atmosphere with an oxygen concentration of less than 1%.
[10] A patterning process for forming a pattern in a substrate to be processed, comprising the steps of:
   (I-1) forming a resist underlayer film on a substrate to be processed by the method for forming a resist underlayer film according to any one of [1] to [9];
   (I-2) forming a resist middle layer film on the resist underlayer film;
   (I-3) forming a resist upper layer film on the resist middle layer film by using a photoresist material;
   (I-4) subjecting the resist upper layer film to pattern exposure and then to development with a developer to form a pattern in the resist upper layer film;
   (I-5) transferring the pattern to the resist middle layer film by dry etching while using the resist upper layer film having the formed pattern as a mask;
   (I-6) transferring the pattern to the resist underlayer film by dry etching while using the resist middle layer film having the transferred pattern as a mask; and
   (I-7) processing the substrate to be processed while using the resist underlayer film having the formed pattern as a mask to form the pattern in the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for forming a resist underlayer film on a substrate, the method comprising the steps of:
(i) forming an underlayer-film-precursor film by coating a substrate with a composition for forming a resist underlayer film, containing (A) a polymer and an organic solvent, to obtain a coating film and subjecting the coating film to heat treatment at a temperature of 100°C or higher and 800°C or lower for 10 seconds to 7,200 seconds to cure the coating film; and
(ii) forming a resist underlayer film by curing the underlayer-film-precursor film by plasma irradiation,
wherein the polymer (A) is an aromatic ring-containing resin containing no hydroxy groups or organic groups represented by the following general formulae (1) in a repeating unit contained in the polymer, 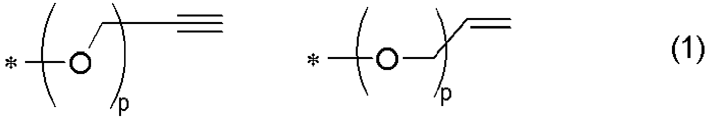 wherein "p" represents 0 or 1, and "*" represents an attachment point.

2. The method for forming a resist underlayer film according to claim 1, wherein the aromatic ring-containing resin of the polymer (A) contains a structure selected from the group consisting of structures shown by the following formulae (1-1).

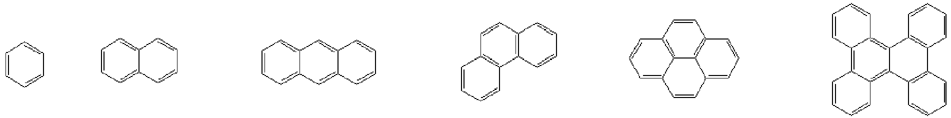

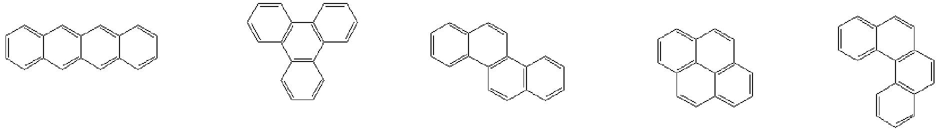

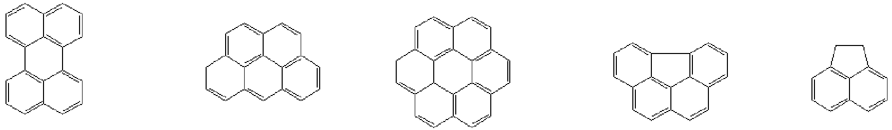

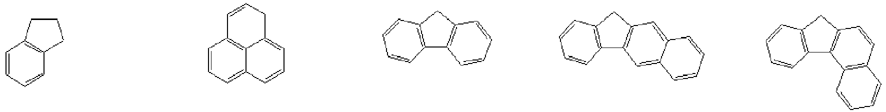

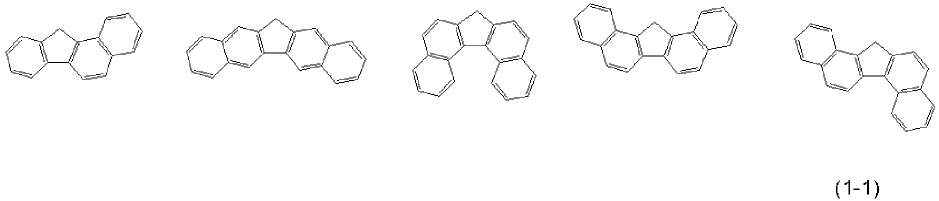

3. The method for forming a resist underlayer film according to claim 1 or 2, wherein the polymer (A) has any of constitutional units represented by the following general formulae (A-1), (A-2), (A-3), (A-4), and (A-5), 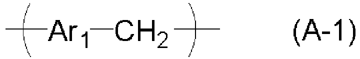 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1), 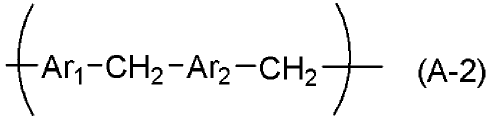 wherein Ar₁ represents an unsubstituted fused aromatic ring or a fused aromatic ring containing, as a substituent, a divalent organic group having 1 to 20 carbon atoms and containing no hydroxy groups or organic groups represented by the general formulae (1); and Ar₂ is a different fused aromatic ring from Ar₁, and represents an unsubstituted fused aromatic ring or a fused aromatic ring containing, as a substituent, a divalent organic group having 1 to 20 carbon atoms and containing no hydroxy groups or organic groups represented by the general formulae (1), 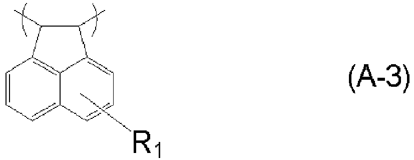 wherein R₁ represents a hydrogen atom, a halogen atom, or a linear, branched, or cyclic hydrocarbon group having 1 to 20 carbon atoms, 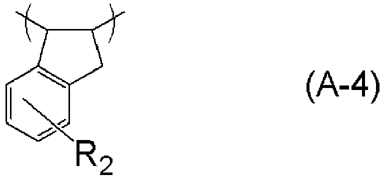 wherein R₂ represents a hydrogen atom, a halogen atom, or a linear, branched, or cyclic hydrocarbon group having 1 to 20 carbon atoms, 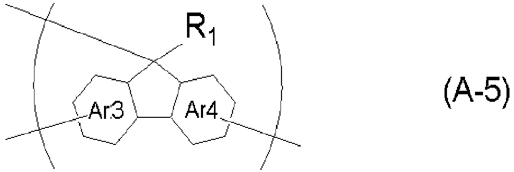 wherein R₁ represents a hydrogen atom or a monovalent organic group having 1 to 50 carbon atoms and containing no hydroxy groups or organic groups represented by the general formulae (1); and Ar3 and Ar4 each represent an unsubstituted benzene ring or naphthalene ring.

4. The method for forming a resist underlayer film according to any one of claims 1 to 3, wherein the polymer (A) has a molecular weight of 300 to 5,000 as measured by gel permeation chromatography in terms of polystyrene.

5. The method for forming a resist underlayer film according to any one of claims 1 to 4, wherein the composition for forming a resist underlayer film further contains one or more of:
(C) a crosslinking agent;
(D) a surfactant;
(E) an acid generator; and
(F) a plasticizer.

6. The method for forming a resist underlayer film according to claim 5, wherein the crosslinking agent (C) has a structure represented by the following general formula (C-1), 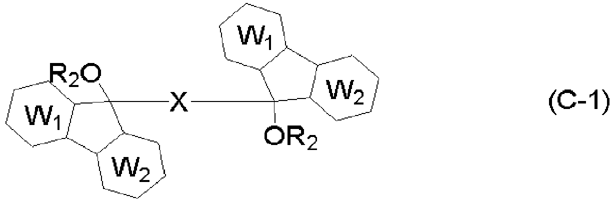 wherein W₁ and W₂ each represent a benzene ring or naphthalene ring optionally having a substituent; R₂ represents a hydrogen atom or a monovalent organic group having 1 to 20 carbon atoms; and X represents any group represented by the following general formulae (2).

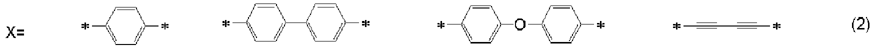

7. The method for forming a resist underlayer film according to any one of claims 1 to 6, wherein the plasma irradiation in the step (ii) is performed under an atmosphere of N₂, NF₃, H₂, fluorocarbon, a rare gas, or a mixture of any thereof.

8. The method for forming a resist underlayer film according to any one of claims 1 to 7, wherein the heat treatment in the step (i) is performed under an atmosphere with an oxygen concentration of 1% or more and 21% or less.

9. The method for forming a resist underlayer film according to any one of claims 1 to 7, wherein the heat treatment in the step (i) is performed under an atmosphere with an oxygen concentration of less than 1%.

10. A patterning process for forming a pattern in a substrate to be processed, comprising the steps of:
(I-1) forming a resist underlayer film on a substrate to be processed by the method for forming a resist underlayer film according to any one of claims 1 to 9;
(I-2) forming a resist middle layer film on the resist underlayer film;
(I-3) forming a resist upper layer film on the resist middle layer film by using a photoresist material;
(I-4) subjecting the resist upper layer film to pattern exposure and then to development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.
